# EUROPÄISCHE PATENTSCHRIFT

(11) **EP 1 151 478 B1**
(45) Veröffentlichungstag und Bekanntmachung des Hinweises auf die Patenterteilung: **28.08.2002**
(21) Anmeldenummer: 99903619.7
(22) Anmeldetag: 11.01.1999
(51) Int. Cl.: H01L 29/78, H01L 21/336

(54) **MOS-LEISTUNGSBAUELEMENT UND VERFAHREN ZUM HERSTELLEN DESSELBEN**
POWER MOS ELEMENT AND METHOD FOR PRODUCING THE SAME
COMPOSANT DE PUISSANCE MOS ET PROCEDE DE FABRICATION DUDIT COMPOSANT

(43) Veröffentlichungstag der Anmeldung: 07.11.2001
(73) Patentinhaber: Fraunhofer-Gesellschaft zur Förderung der angewandten Forschung e.V., 80636 München (DE)
(72) Erfinder: WAHL, Uwe, D-50733 Köln (DE); VOGT, Holger, D-45481 Mülheim (DE)
(74) Vertreter: Schoppe, Fritz, Dipl.-Ing.
(86) Internationale Anmeldenummer: EP9900109
(87) Internationale Veröffentlichungsnummer: WO00042665

(56) Entgegenhaltungen:
- EP-A- 0 205 639
- EP-A- 0 583 023
- WO-A-96/35231
- WO-A-97/33309
- US-A- 5 689 128
- US-A- 5 763 915
- MATSUMOTO S ET AL: "A HIGH-PERFORMANCE SELF-ALIGNED UMOSFET WITH A VERTICAL TRENCH CONTACT STRUCTURE" IEEE TRANSACTIONS ON ELECTRON DEVICES, Bd. 41, Nr. 5, 1. Mai 1994 (1994-05-01), Seiten 814-818, XP000483880 ISSN: 0018-9383 in der Anmeldung erwähnt
- RITTENHOUSE G E ET AL: "A LOW-VOLTAGE POWER MOSFET WITH A FAST-RECOVERY BODY DIODE FOR SYNCHRONOUS RECTIFICATION" PROCEEDINGS OF THE ANNUAL POWER ELECTRONICS SPECIALISTS CONFERENCE (PESC), SAN ANTONIO, JUNE 11 - 14, 1990, Bd. 1, Nr. CONF. 21, 11. Juni 1990 (1990-06-11), Seiten 96-106, XP000173908 INSTITUTE OF ELECTRICAL AND ELECTRONICS ENGINEERS ISSN: 0275-9306
- PATENT ABSTRACTS OF JAPAN vol. 096, no. 011, 29. November 1996 (1996-11-29) & JP 08 186258 A (HITACHI LTD), 16. Juli 1996 (1996-07-16)
- PATENT ABSTRACTS OF JAPAN vol. 015, no. 148 (E-1056), 15. April 1991 (1991-04-15) & JP 03 024765 A (TOYOTA AUTOM LOOM WORKS LTD), 1. Februar 1991 (1991-02-01)
- MATSUMOTO S ET AL: "A 70-V, 90-m Omega mm/sup 2/, high-speed double-layer gate UMOSFET realized by selective CVD tungsten" PROCEEDINGS OF THE 6TH INTERNATIONAL SYMPOSIUM ON POWER SEMICONDUCTOR DEVICES AND ICS. ISPSD '94 (IEEE CAT. NO.94CH3377-9), PROCEEDINGS OF ISPSD'94 INTERNATIONAL SYMPOSIUM ON POWER SEMICONDUCTOR DEVICES AND IC'S, DAVOS, SWITZERLAND, 31 MAY-2 JUNE 199, Seiten 365-369, XP000505839 1994, Konstanz, Germany, Hartung-Gorre Verlag, GermanyISBN: 3-89191-784-8

## Beschreibung

Die vorliegende Erfindung bezieht sich auf ein MOS-Leistungsbauelement und auf ein Verfahren zum Herstellen desselben und insbesondere auf ein vertikales MOS-Leistungsbauelement, dessen Gate eine Mehrzahl von Gräben oder Trenches aufweist, und dessen Source- und Gate-Kontakt auf der Vorderseite desselben ist, während der Drain-Kontakt auf der Rückseite desselben ist, derart, daß der Stromfluß durch das Elemente im wesentlichen senkrecht zu der Vorder- und der Rückseite, d. h. vertikal, ist.

Vertikale Leistungs-MOSFET-Strukturen sind seit längerer Zeit bekannt. Bereits 1985 haben Daisuke Ueda u. a. in "New Vertical Power MOSFET Structure with Extremly Reduced On-Resistance", IEEE Transactions on Electron Devices, Bd. ED-32, Nr. 1, Januar 1985, ein MOS-Leistungsbauelement mit einem Grabengate vorgestellt. Hierbei befindet sich das Gate nicht lateral an der Waferoberfläche sondern vertikal auf den Seitenflächen von im Plasma anisotrop geätzten Gräben. Das Element weist einen ganzflächigen Rückseiten-Drain-Kontakt auf und einen Source-Kontakt an der Oberseite.

Bei vertikalen Leistungs-MOS-Transistoren dieses Typs steigt der Anteil des Kanalwiderstands am gesamten Einschaltwiderstand mit sinkender Spannungsfestigkeit. Um die Verlustleistung am Transistor zu senken, ist entweder die Chipfläche zu vergrößern oder die Kanalweite des Transistors zu erhöhen. Die Graben- oder "Trench"-Technologie ermöglicht eine deutlich höhere Kanalweite pro aktiver Transistorfläche als die herkömmliche DMOS-Technologie, da hier lediglich Technologie- und nicht wie beim DMOS-Konzept elektrische Parameter der limitierende Faktor sind.

In "A High-Performance Self-Aligned UMOSFET with a Vetical Trench Contact Structure" von S. Matsumoto u. a., IEEE Trans. Electr. Dev., Bd. 41, Nr. 5, Mai 1994, ist ein MOS-Leistungsbauelement offenbart, das als Schichtenfolge eine stark n-dotierte Source-Schicht, eine p-dotierte Kanalschicht, eine schwach n-dotierte Driftschicht und eine stark n-dotierte Substratschicht aufweist, an der der Rückseiten-Drain Kontakt angebracht ist. Mit Poly-Silizium gefüllte Gräben, die nach oben hin durch Siliziumdioxid isoliert sind, bilden die Gate-Gräben. Der Source-Kontakt auf der Oberseite des Bauelements ist über ein mit Metall gefülltes Kontaktloch sowohl mit dem Source-Bereich als auch mit dem Kanal-Bereich verbunden, um sowohl den Source-Bereich als auch den Kanal-Bereich auf einem gleichen Potential zu halten. Durch die gleichzeitige Kontaktierung des Source-Bereichs und des Kanal-Bereichs mittels eines Kontaktlochs wird ein platzsparendes Schaltungsdesign erreicht. Da bei der Ausbildung des Kontaktlochs hohe Aspektverhältnisse entstehen, muß eine Metallisierung eingesetzt werden die sich konform abscheiden läßt, um die Kontaktlöcher ohne Leerräume aufzufüllen. Dazu wird Wolfram verwendet.

In "A High-Density Self-Aligned 4-Mask-Planar VDMOS Process" von D. Kinzer, u. a., Proc.-ISPSD'96, 20. bis 23. Mai 1996, Maui, USA, S. 243-247, ist ein gängiges Herstellungsverfahren für Leistungs-MOS-Transistoren dargestellt. Zur Herstellung werden üblicherweise vier Masken verwendet, wobei die erste Maske dazu dient, eine Öffnung in einem Feldoxid zu erzeugen, in der die aktiven Zellen aufgenommen werden sollen. Die zweite Maske ist die Gatemaske. Die dritte Maske dient als Kontaktmaske, und die vierte und letzte Maske ist die Metallmaske. Diese Maske trennt das Sourcemetall von dem Gatemetall. Der Gatekontakt wird direkt über dem aktiven Gate über der ganzen Gatebreite vorgenommen. Wenn diese Technologie auf Leistungsbauelemente mit Grabengates angewendet wird, ist zusätzlich eine weitere Maskierung notwendig, um die Gategraben zu erzeugen. Damit werden üblicherweise fünf Masken eingesetzt, um vertikale Leistungsbauelemente mit Gategräben herzustellen.

Während von Ueda, Matsumoto und Kinzer vertikale MOS-Leistungsbauelemente beschrieben werden, die auf bzw. in einem schichtförmig dotierten Halbleitersubstrat gebildet sind, beschreiben Richard K. Williams u. a. in "A 30-V P-channel Trench Gated DMOSFET with 900 µΩ-cm² Specific On-Resistance at 2.7 V", Proc-ISPSD'96, 20. bis 23. Mai 1996, Maui, USA, Seiten 53-57, ein vertikales Leistungsbauelement mit lokal ausgebildeten p- und n-Gebieten zur Ausformung des Kanalund des Sourcebereichs.

Eine ganzfläche unmaskierte Erzeugung der Dotiergebiete ist in der WO 93/26047, beschrieben. Ein darin offenbarter Siliziumkarbid-Leistungs MOSFET umfaßt einen aktiven Bereich und einen Anschlußbereich. Der Anschlußbereich dient dazu, die Spannungsfestigkeit des Leistungsbauelements zu den Schneidekanten desselben hin bzw. zu dem Rand des Wafers hin zu erhöhen, derart, daß keine Randdurchbrüche an Randoberflächen die Leistungsfestigkeit begrenzen. Der aktive Bereich umfaßt einen zu dem Drift-, dem Kanal- und dem Source-Bereich hin isolierten Gategraben, der mittels eines bekannten Ionengrabenätzverfahrens hergestellt wird. Nach einer Oxidation wird der Graben mit Polysilizium oder Metall aufgefüllt. Der Gate-Graben wird über einen (Polysilizium-) Gatekontakt kontaktiert, während ein Source- und ein Drainkontakt an der Vorder- bzw. Rückseite des Bauelements angebracht werden. Nicht-kontaktierte Gräben im Randbereich sind vorgesehen, um potentialmäßig "schwebende" oder "floatende" Feldplatten bzw. Feldringe zu bilden.

Die WO 95/09439 beschreibt ein weiteres Siliziumkarbid-Feldeffektbauelement. Dasselbe umfaßt mehrere Gategräben, die in einem schichtartig dotierten Substrat gebildet sind. Die Gräben enthalten als leitfähiges Material Polysilizium, das mittels eines Isolators isoliert ist. Das Substrat enthält auf der Oberseite einen großflächigen Source-Kontakt und an der Rückseite einen großflächigen Drain-Kontakt. Die Gate-Gräben sind durch Durchgangslöcher in dem Source-Kontakt und dem Isolator, der das leitfähige Material im Gategraben umgibt, kontaktiert. Mehrere FET-Einzelelemente werden parallel geschaltet, indem die leitfähigen Gateelektroden mittels einer vom Sourcekontakt isolierten Metallisierung, die über dem Source-Kontakt angeordnet ist, miteinander verbunden werden.

Nachteilig an diesem bekannten MOS-Leistungsbauelement ist, daß nach dem Herstellen des Source-Kontakts in einem weiteren Maskierungsprozeß Durchgangslöcher in den Source-Metallkontakt und den darunterliegenden Gate-Isolator gebildet werden müssen, um die Gate-Elektroden in den Gate-Gräben kontaktieren zu können. Sollen diese Gate-Gräben parallel geschaltet werden, um hohe Ströme verarbeiten zu können, so sind zusätzlich weitere Schritte zum Isolieren der Durchgangslöcher zu den Gate-Gräben, und zum Strukturieren der Gate-Elektrode, die über der Source-Elektrode angeordnet wird, nötig, wodurch das Herstellungsverfahren aufwendig wird, da zwei übereinander liegende Metallisierungsschichten vorhanden sind, die voneinander isoliert sein müssen. Außerdem erfordert das bekannte MOS-Leistungsbauelement weitere Schritte zum Kontaktieren des Kanal-Bereichs, der üblicherweise, wie es in Ueda ausgeführt ist, auf das gleiche Potential wie der Source-Bereich gelegt wird.

Das US-Patent Nr. 5,763,915 offenbart einen DMOS-Transistor mit einem quadratisch verzweigten Gate-Graben, in dem Polysilizium angeordnet ist, das von dem umgebenden Halbleitermatierial durch ein Gate-Oxid getrennt ist. Der Gate-Graben definiert Quadrate, welche einzelne Transistorzellen festlegen, wobei in jedem Quadrat ein Source-Kontakt angeordnet ist, wobei die Mehrzahl von Source-Kontakten zusammen mit einem rückseitigen Drain-Kontakt eine Mehrzahl von parallel geschalteten Einzeltransistoren bilden, welche den DMOS-Transistor insgesamt bilden. Der quadratisch verzweigte Gate-Graben ist über eine Mehrzahl von parallelen Gate-Läufern, die ebenfalls als Graben ausgeführt sind, mit einem Anschluß-Graben verbunden. Der Source-Kontakt ist über eine durchgehende Metallfläche über den Einzeltransistoren hergestellt, wobei der Source-Kontakt über Durchgangslöcher durch ein Oxid mit den Source-Bereichen in Verbindung ist. Der Gate-Kontakt ist über Durchgangslöcher mit dem Anschluß-Graben, welcher breiter als der Gate-Graben und die Gate-Läufer ist, verbunden.

Die EP-A-0 583 023 offenbart ein Verfahren zum Herstellen eines DMOS-Transistors, bei dem sechs Maskenschritte verwendet werden. Der DMOS-Transistor umfaßt eine Terminierungsstruktur mit mehreren Feldringen, wobei jeder Satz von benachbarten Feldringen durch einen Isolationsgraben getrennt ist, so daß die Feldringe nahe aneinander angeordnet werden können. Die Feldringe und die Gräben werden in denselben Schritten wie entsprechende Teile des aktiven Transistors hergestellt.

Die Aufgabe der vorliegenden Erfindung besteht darin, ein flexibel gestaltbares MOS-Leistungsbauelement zu schaffen, dessen Herstellung mit einer minimalen Anzahl von Schritten erreicht wird.

Diese Aufgabe wird durch ein MOS-Leistungsbauelement nach Anspruch 1 und durch ein Verfahren zum Herstellen eines MOS-Leistungsbauelements nach Anspruch 16 gelöst.

Der vorliegenden Erfindung liegt die Erkenntnis zugrunde, daß von einer herkömmlichen Kontaktierung der einzelnen Gategräben, um eine Parallelschaltung der Einzeltransistoren zu erreichen, weggegangen werden muß. Statt einer herkömmlichen Kontaktierung jedes einzelnen Gategrabens wird daher erfindungsgenäß ein Anschlußgategraben vorgesehen, in den die einzelnen Gategräben münden, bzw. der die einzelnen Gategräben elektrisch miteinander verbindet. Die Hauptfunktion dieses Anschlußgategrabens besteht nicht mehr darin, einen Strom durch einen Kanal zu steuern, sondern darin, die einzelnen Gategräben miteinander zu verbinden. Daher ist die Breite dieses Gategrabens relativ beliebig wählbar, was für die Breite der aktiven Gategräben nicht unbedingt zutrifft, da hier elektrische Parameter des MOS-Leistungsbauelements festgelegt werden. Vorzugsweise wird die Breite des Anschlußgategrabens daher größer gewählt, damit auf sichere und zuverlässige Art und Weise ohne das Risiko eines hohen Ausschusses Kontaktlöcher in den Anschlußgategraben erzeugt werden können, über die ein flächiger Gatekontakt mittels einer Kontaktlochfüllung mit dem Anschlußgategraben und damit den aktiven Gategräben in Verbindung steht, um ein geeignetes Gate-Potential an das vertikale MOS-Leistungsbauelement anlegen zu können.

Das erfindungsgemäß MOS-Leistungsbauelement kann vollständig mittels nur dreier photolithographischer Schritte hergestellt werden. Es wird keine eigene Maske zur Dotierung lokaler p- oder n-Gebiete benötigt. Stattdessen wird ein Substrat mit einem Driftbereich, einem Kanalbereich und einem Sourcebereich verwendet, wobei die drei Bereiche eine schichtartige Anordnung bilden. Der erste photolithographische Schritt dient zum Erzeugen der Mehrzahl von Gategräben und des Anschlußgategrabens und vorzugsweise kann in diesem Schritt auch eine Terminierungsstruktur definiert werden, die entweder mehrere um den aktiven Bereich herum angeordnete floatende Gräben aufweist, oder in Analogie zu einer Feldplattenstruktur einen mit dem Source-Bereich und dem Drain-Bereich kurzgeschlossenen Grabenabschnitt umfaßt.

Der zweite photolithographische Schritt dient zum Erzeugen der Kontaktlöcher zur Kontaktierung des Sourcebereichs und des Kanalbereichs sowie zur Kontaktierung des Anschlußgategrabens. Es sei darauf hingewiesen, daß die aktiven Gategräben nicht extern kontaktiert sind, sondern lediglich durch den Anschlußgategraben. Der dritte photolithographische Schritt dient schließlich dazu, die Metallkontakte zu strukturieren, derart, daß ein großflächiger Sourcekontakt vorgesehen wird, der im wesentlichen das gesamte MOS-Leistungsbauelement bedeckt, mit Ausnahme eines Bereichs über dem Anschlußgategraben, der von dem flächigen Gatekontakt eingenommen wird. Sind spezielle Randstrukturen vorgesehen, so ist auch über diesen kein Sourcekontakt vorhanden.

Bevorzugterweise ist der Anschlußgategraben ein um den aktiven Bereich herum angeordneter geschlossener Graben, der die aktiven Gategräben an beiden Enden derselben kontaktiert, um an beiden Enden der Gategräben das Gatepotential zuführen zu können. Diese Anordnung hat den Vorteil, daß bereits hier eine Eingrenzung des aktiven Bereichs innerhalb der Schneidekante des MOS-Leistungsbauelements erreicht ist, die bei nicht allzu großen Drain-Source-Spannungen an dem MOS-Leistungsbauelement ausreicht, um Randdurchbrüche zu vermeiden. Somit kann bei geringeren Spannungsklassen auf jegliche Art einer speziellen Randterminierung verzichtet werden, wodurch Kosten eingespart werden können, was insbesondere in Massenmärkten, wie z. B. der Kfz-Industrie oder dem Consumer-Bereich, von wesentlicher Bedeutung ist.

Die Kontaktierung der Gategräben über einen eigenen Anschlußgategraben ermöglicht somit ohne zusätzliche Technologieschritte eine Plazierung der physischen Gatekontakte wie vom Benutzer gefordert, entweder am Rand des MOS-Leistungsbauelements oder in der Mitte des MOS-Leistungsbauelements oder allgemein an jeder beliebigen Stelle, da die Plazierung des Gatekontakts durch den Anschlußgategraben von der Lage der aktiven Gategräben entkoppelt ist.

Bevorzugte Ausführungsbeispiele der vorliegenden Erfindung werden nachfolgend bezugnehmend auf die beiliegenden Zeichnungen detailliert erläutert. Es zeigen:
- Fig. 1: eine Draufsicht auf ein MOS-Leistungsbauelement, bei dem der Gate-Kontakt am Rand des Bauelements angeordnet ist;
- Fig. 2: eine Draufsicht auf ein MOS-Leistungsbauelement, bei dem der Gatekontakt in der Mitte des Bauelements angeordnet ist;
- Fig. 3: eine Draufsicht auf ein MOS-Leistungsbauelement, bei dem der Gate-Kontakt in der Mitte des Bauelements angeordnet ist und die Gategräben rechtwinklig mit dem Anschlußgategraben verbunden sind;
- Fig. 4A bis 4D: eine Folge von Querschnitten durch das MOS-Leistungsbauelement von Fig. 1 entlang der Linie A-A von Fig. 1;
- Fig. 5A bis 5C: eine Querschnittsdarstellung des erfindungsgemäßen MOS-Leistungsbauelements während verschiedener Herstellungsschritte entlang der Linie A-A von Fig. 1, wobei verschiedene Prozeßvarianten dargestellt sind;
- Fig. 6: eine Querschnittsdarstellung des MOS-Leistungsbauelements von Fig. 1 entlang der Linie B-B mit einer Randterminierungsstruktur in Analogie zu floatenden umlaufenden Ringen; und
- Fig. 7: eine Querschnittsansicht des MOS-Leistungsbauelements von Fig. 1 entlang der Linie B-B mit einer Randterminierungsstruktur in Analogie zu floatenden Feldplatten.

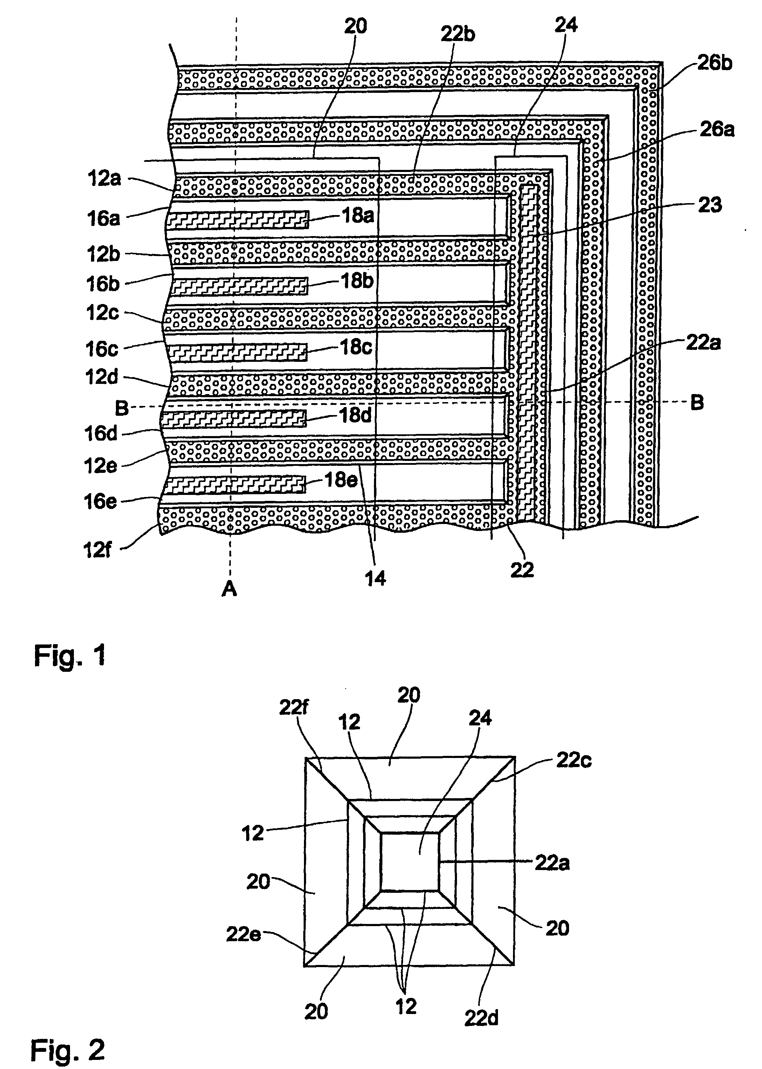

Fig. 1 zeigt eine Draufsicht auf das erfindungsgemäße MOS-Leistungsbauelement gemäß der vorliegenden Erfindung. Es sei darauf hingewiesen, daß Fig. 1 lediglich einen Abschnitt des MOS-Leistungsbauelements zeigt, der beispielsweise an der senkrechten und waagrechten Achse gespiegelt werden könnte, um z. B. ein vollständiges im wesentlichen quadratisches MOS-Leistungsbauelement zu erhalten. Wie es bekannt ist, umfassen MOS-Leistungsbauelemente eine Vielzahl von parallel geschalteten Einzeltransistoren, derart, daß der Drain-Source-Strom pro Einzeltransistor relativ klein ist, da sich der Gesamtstrom in das MOS-Leistungsbauelement in die verschiedenen Einzelströme aufteilt. Zum verlustarmen Schalten großer Ströme ist es wichtig, daß der gesamte On-Widerstand des MOS-Leistungsbauelements klein ist. Dies wird bei einer Parallelschaltung vieler einzelner Transistoren ohne weiteres erreicht, da der gesamte On-Widerstand die Parallelschaltung aller einzelner On-Widerstände ist. Andererseits bewirkt die Parallelschaltung aller Einzeltransistoren, daß die hohe Spannung, die von einem MOS-Leistungsbauelement bewältigt werden muß, an jedem einzelnen Transistor gleich anliegt, was insbesondere bei den am Rand eines MOS-Leistungsbauelements, d. h. in der Nähe der Sägekante, angeordneten Transistoren über Oberflächeneffekte zu Durchbrüchen führen kann. Daher können besondere Vorkehrungen getroffen werden, um für höhere Spannungsklassen einen derartigen Randdurchbruch zu unterbinden.

Fig. 1 zeigt eine Mehrzahl von einzelnen Gategräben 12a bis 12f, die über einen Isolator 14, d. h. das Gateoxid, von jeweiligen Sourcebereichen 16a bis 16e isoliert sind. Die Source-Bereiche 16a bis 16e sind über Source-Kontaktlöcher 18a bis 18e, die mit einem leitfähigen Material gefüllt sind, mit einem großflächigen Source-Kontakt 20 verbunden, der aus Übersichtlichkeitsgründen in Fig. 1 "durchsichtig" gezeichnet ist. Die einzelnen Gate-Gräben 12a bis 12f münden alle in einen Anschlußgategraben 22, der über Kontaktlöcher, die mit einem leitfähigen Material gefüllt sind, mit einem Gatekontakt 24 verbunden sind.

Aus Fig. 1 ist zu sehen, daß der Anschlußgategraben einen Verbindungsbereich 22a und einen Längsbereich 22b aufweist, derart, daß der Anschlußgategraben den aktiven Bereich des MOS-Leistungsbauelements umschließt. Für kleinere Drain-Source-Spannungen wird die Eingrenzung des aktiven Bereichs durch den Anschlußgategraben 22 bereits genügen, damit keine Randdurchbrüche auftreten. Für höhere Spannungsklassen kann eine Randterminierungsstruktur vorgesehen werden, die bei dem in Fig. 1 gezeigten Ausführungsbeispiel einen ersten Randterminierungsgraben 26a und einen zweiten Randterminierungsgraben 26b umfaßt. Wie es später dargestellt wird, existieren Alternativen zum Ausgestalten der Randterminierungsstruktur.

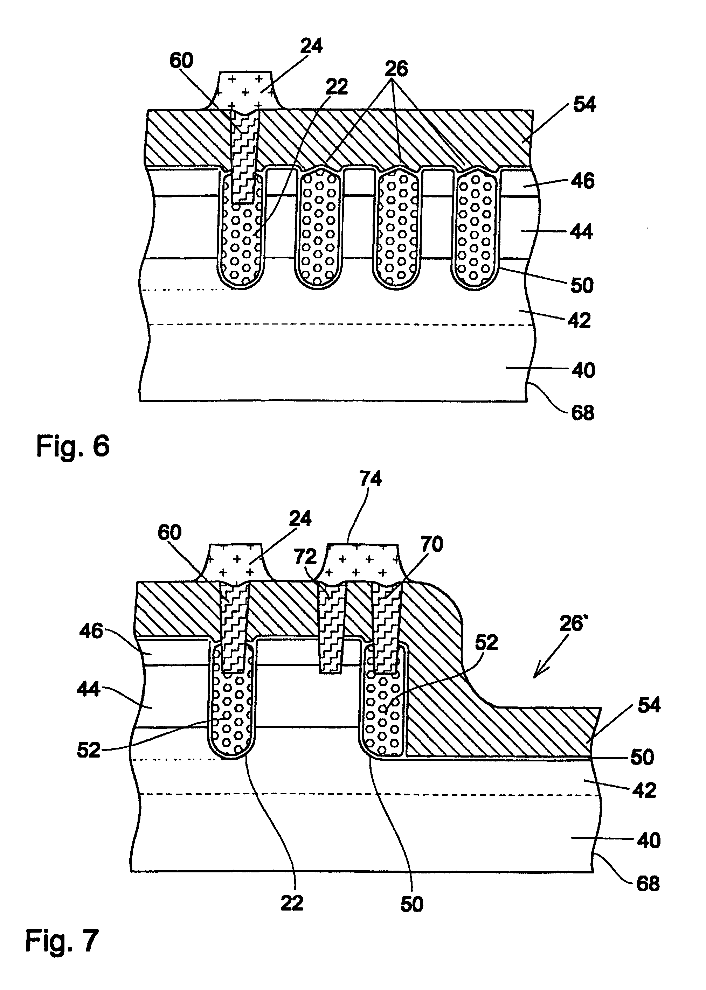

Das erfindungsgemäße MOS-Leistungsbauelement kann mit nur drei Masken- und Lithographieschritten durch minimalen Prozeß- und damit Kostenaufwand hergestellt werden. Der erste Photolithographieschritt wird dabei verwendet, um die Mehrzahl von Gategräben 12a bis 12f, den Gateanschlußgraben 22 und die Randterminierungsgräben 26a, 26b herzustellen. Der zweite Lithographieschritt wird dazu verwendet, um die Kontaktlöcher 18a bis 18e für den Sourcebereich und die Kontaktlöcher 23 für den Gate-Bereich herzustellen. Der dritte und letzte Lithographieschritt wird dazu verwendet, um den Source-Kontakt 20 und den Gate-Kontakt 24 sowie eventuelle Oberflächen-Metallstrukturen für die Randterminierung (siehe Fig. 6) zu definieren.

Fig. 2 zeigt eine Draufsicht auf eine alternative Ausführungsform des MOS-Leistungsbauelements, bei dem der Gate-Kontakt 24 in der Mitte des Bauelements angeordnet ist, während um den Gate-Kontakt 24 herum der Source-Kontakt 20 angebracht ist. Das MOS-Leistungsbauelement, das in Fig. 2 dargestellt ist, umfaßt ferner eine Vielzahl von Gategräben 12, die in jedem Viertel des MOS-Leistungsbauelements parallel zueinander angeordnet sind, wie es in Fig. 2 gezeigt ist. Es sei darauf hingewiesen, daß lediglich einige wenige Gategräben gezeigt sind. Es ist jedoch klar, daß sich unter dem Source-Kontakt 20 eine Vielzahl von weiteren in Fig. 2 nicht gezeigten Gategräben befindet. Die einzelnen im wesentlichen parallelen Gategräben sind über den Anschlußgraben 22 miteinander verbunden. Der Gateanschlußgraben 22 umfaßt vier Auslegerabschnitte 22c bis 22f, die sich jeweils diagonal erstrecken, um die einzelnen aktiven Gategräben miteinander zu verbinden. Dieselben münden in einen breiteren Verbindungsbereich 22a des Gateanschlußgrabens, der wieder, wie es in Fig. 1 gezeigt ist, über Kontaktlöcher (in Fig. 2 nicht gezeigt) mit dem Gate-Kontakt 24 verbunden ist.

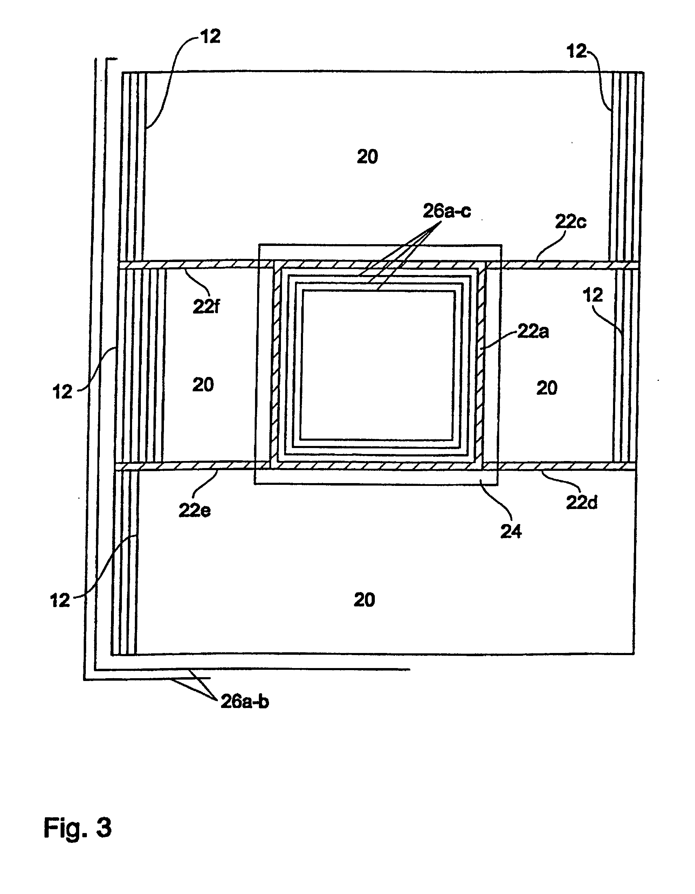

Fig. 3 zeigt eine Draufsicht auf ein MOS-Leistungsbauelement, bei dem der Gate-Kontakt 24 ebenfalls in der Mitte angeordnet ist. Im Unterschied zu dem in Fig. 2 gezeigten Ausführungsbeispiel verlaufen hier die Auslegerabschnitte 22c bis 22f des Anschlußgategrabens 22 nicht diagonal, sondern parallel zueinander. Dieselben stehen mit dem Verbindungsabschnitt 22a des Anschlußgategrabens wiederum in Verbindung, über dem der Gate-Kontakt 24 angeordnet ist und mittels geeigneter Kontaktlöcher (in Fig. 3 nicht gezeigt) über den Anschlußgategraben mit den Gategräben 12 elektrisch verbunden ist. Das in Fig. 3 gezeigte Ausführungsbeispiel umfaßt ferner Randterminierungsgräben 26a bis b um den aktiven Bereich herum und zusätzlich Randterminierungsgräben 26a bis c in der Mitte des aktiven Bereichs, wo der Gate-Kontakt 24 gebildet ist. Somit wird sichergestellt, daß der gesamte aktive Bereich des MOS-Leistungsbauelements abgesichert ist, derart, daß keine Oberflächeneffekte auftreten können, die die maximal anlegbare Drain-Source-Spannung reduzieren könnten. Aus Fig. 3 ist deutlich, daß in Analogie zu Fig. 1 der Anschlußgategraben auch um das ganze Element herum ausgeführt sein könnte, derart, daß ohne zusätzliche Randterminierungsstrukturen bereits eine gewisse Randterminierung erreicht wird, die für kleinere Drain-Source-Spannungen allein genügen wird. In diesem Falle dient der Anschlußgategraben sowohl zum elektrischen Verbinden der einzelnen aktiven Gategräben, d. h. zum Parallelschalten der Einzeltransistoren, als auch zum Liefern einer gewissen Randterminierung.

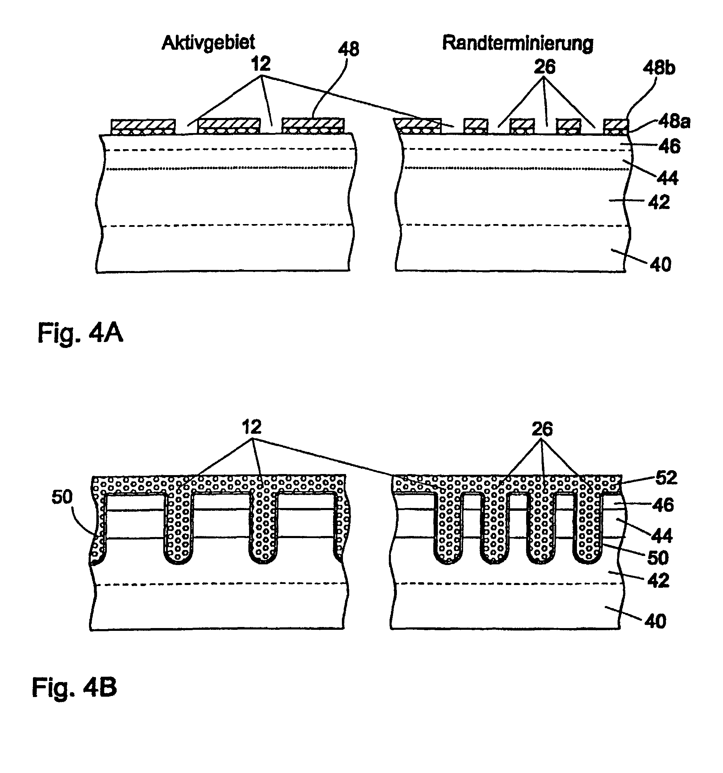

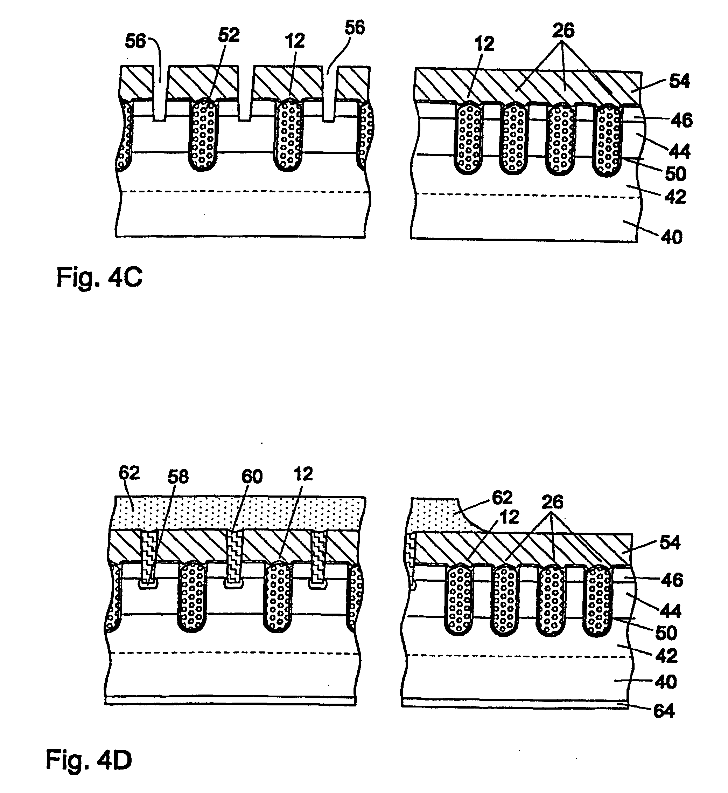

Die Fig. 4A bis 4D zeigen verschiedene Herstellungsstufen des MOS-Leistungsbauelements anhand eines Querschnitts entlang der Linie A-A von Fig. 1. Fig. 4A zeigt das MOS-Leistungsbauelement gemäß der vorliegenden Erfindung zu Beginn seiner Herstellung. Es umfaßt einen Drain-Bereich 40, der stark n-dotiert ist. An diesen stark n-dotierten Drainbereich schließt sich ein schwach n-dotierter Driftbereich 42 an, auf dem wiederum ein p-dotierter Kanalbereich 44 gebildet ist. Ein stark n-dotierter Sourcebereich 46 bildet die Oberfläche des Halbleitersubstrats, auf dem gemäß der Darstellung in Fig. 4A bereits eine Grabenätzmaske 48 gebildet ist, die bei einem bevorzugten Ausführungsbeispiel der vorliegenden Erfindung zweischichtig ist und aus einer Nitridschicht 48a und einer Oxidschicht 48b besteht. Die erste Maske 48 definiert die Gategräben 12 sowie die Randterminierungsgräben 26 sowie den Anschlußgategraben (in Fig. 4 nicht gezeigt).

Obwohl in dieser Anmeldung NMOS-Transistoren beschrieben werden, ist es für Fachleute offensichtlich, daß sich alle Ausführungen in dieser Anmeldung ebenfalls auf PMOS-Transistoren beziehen können, wobei in diesem Fall lediglich die n-Dotierungen durch p-Dotierungen und umgekehrt zu ersetzen sind.

Wie es aus Fig. 4 ersichtlich ist, werden die Dotierungen der Schichten 42 bis 46 nicht lokal mittels eines speziellen Dotierungsmaskenprozesses hergestellt, sondern ganzflächig.
Dazu wird auf dem hochdotierten n-Substrat 40, das z. B. aus Silizium besteht, zunächst eine mit Phosphor niedrig dotierte Schicht aufgewachsen, um den Driftbereich zu bilden. Auf diese niedrig dotierte Schicht kann dann eine mit Bor dotierte Schicht epitaktisch aufgewachsen werden, die den Kanalbereich 44 definiert. Auf dieser p-dotierten Schicht mit der für die Schwellenspannung notwendigen Dotierung kann dann eine mit Arsen oder Phosphor sehr hoch dotierte Schicht aufgewachsen werden, um den Sourcebereich 46 zu bilden. Alternativ können die Schichten 44 und 46 auch durch ganzflächige Implantation in einer schwach n-dotierten Epitaxieschicht erzeugt werden, welche mindestens eine Dicke aufweist, die der Summe der Schichten 42 und 44 entspricht. Selbstverständlich können, wie es für Fachleute bekannt ist, die Techniken des Implantierens und des epitaktischen Aufwachsens kombiniert werden. Wird das Dotierprofil durch eine Kombination aus Epitaxie und Implantation durchgeführt, d. h., Erzeugung des Kanalgebiets 44 durch Epitaxie und Erzeugung des Sourcegebiets 46 durch Implantation, so erfolgt die Source-Implantation erst nach dem Ätzen der Graben oder Trenche und dem Wiederauffüllen derselben, wie es später dargelegt wird.

Alternativ könnte auch ein Halbleitersubstrat genommen werden, in das ein Kanalbereich und ein Sourcebereich implantiert wird. Nach Fertigstellung der Oberseite könnte die Anordnung auf der Rückseite bis zu einer Dicke von 20 µm rückgeschliffen werden, um dann in die Rückseite einen Bereich mit hoher Dotierung zu implantieren, auf dem schließlich der Rückseiten-Drainkontakt aufgebracht wird. In diesem Falle würde kein einziger Epitaxieschritt benötigt werden.

Allen einzelnen Implantationsschritten schließen sich entweder nach jeder einzelnen oder im Anschluß an die direkt nacheinander ausgeführten Implantationen Ausdiffusionsschritte im Ofen bei Temperaturen zwischen 900°C und 1100°C an. Die Dicke der Epitaxieschichten bzw. die Ausdiffusionszeiten der Implantationen bestimmen das für die jeweilige Spannungsklasse notwendige Dotierprofil. Bei der Erzeugung des Dotierprofils mit Hilfe von Implantationen wird vorzugsweise zuvor ein sogenanntes Screeningoxid in einer tpyischen Dicke von 28 nm aufgebracht.

Wie es bereits ausgeführt worden ist, ist in Fig. 4A die erste Maske 48 gezeigt, welche je nach verwendetem Grabenätzprozeß eine Lackmaske oder eine Hartmaske bestehend aus der Schichtenfolge Nitrid (48a) und Oxid (48b) ist. Die Schichten der Hartmaske werden als CVD (CVD = Chemical Vapor Deposition) oder/und als LP-Schicht erzeugt. Die Hartmaske könnte alternativ auch nur aus Oxid bestehen.

Nach dem Ätzen der Graben erfolgen eine oder mehrere Reinigungsoxidationen, welche vor der Erzeugung eines Gatedielektrikums 50 wieder entfernt werden. Für das Gatedielektrikum 50 wird ein thermisches DCE-Oxid (DCE = Dichlorethan) mit einer nominalen Dicke von 53 nm bevorzugt. Es können jedoch auch andere Schichtdicken oder ein Dielektrikum bestehend aus einer Oxid/Nitrid/Oxid-Schicht, wie es in ähnlicher Form bei der DRAM-Herstellung verwendet wird, eingesetzt werden.

Die Gräben 12, 26, 22 (Fig. 1) werden anschließend mit einem leitfähigen Material 52 aufgefüllt. Dazu kann entweder n⁺dotiertes Polysilizium verwendet werden. Alternativ eignet sich auch eine Kombination einer dünnen Polysiliziumschicht mit einer Schicht aus CVD-Wolfram, die den Graben jeweils komplett auffüllt. Durch Silizidierung kann man einen äußerst niederohmigen Gateanschluß erreichen, wie es für schnelle Leistungs-MOS-Transistoren nötig ist, die im Bereich über 500 MHz eingesetzt werden.

Das zum Auffüllen der Gräben verwendete leitfähige Material 52 wird entweder in einem Plasma- oder Naßätzprozeß oder mittels CMP (CMP = Chemical Mechanical Planarisation) ganzflächig abgetragen, so daß das Füllmaterial der Gräben in den Gräben als Inseln zurückbleibt (siehe Fig. 4C, 4D).

Alternativ kann hier, wie es bereits vorher angedeutet wurde, die Sourceimplantation durchgeführt werden. Die Aktivierung der implantierten Dotierstoffe erfolgt entweder über einen zusätzlichen Temperaturschritt, oder, wenn BPSG (Bor-Phosphor-Silicatglas) oder Silanoxid als Zwischenoxid verwendet wird, während des Reflows oder während der Wolframsilizidierung.

Wie es in Fig. 4C angedeutet ist, wird nach einer Entfernung des überschüssigen leitfähigen Materials 52 eine Isolation der Gräben zur Scheibenoberfläche hin durch eine Niedertemperatur-CVD-Abscheidung von Isolatorschichten 54 erreicht. Möglich sind CVD-Oxide dotiert (BPSG) und undotiert oder Kombinationen aus Oxid und Nitrid. Durch Einsetzen derartiger Materialien als Zwischenoxid 54 kann auf eine abschließende Passivierung verzichtet werden, wodurch die Kosten für das Element weiter reduziert werden können.

Mittels einer geeigneten Maske (in Fig. 4C nicht gezeigt) werden Kontaktlöcher 56 in das Zwischenoxid 54, in den Gateisolator 50, den Sourcebereich 46 und in den Kanalbereich 44 hinein geätzt. Für das Kontaktlochätzen wird der zweite Schritt des photolithographischen Erzeugens eingesetzt, der einen Maskierungsschritt und einen Ätzschritt umfaßt. Obwohl es in Fig. 4C nicht gezeigt ist, sei darauf hingewiesen, daß gleichzeitig mit dem Ätzen der Kontaktlöcher 56 auch die Kontaktlöcher in den Anschlußgategraben (22 in Fig. 1) gebildet werden. Die Gate-Kontaktierung erfolgt daher gleichzeitig zu der Source- und der Kanalkontaktierung. Zur Herstellung der Gate-Kontaktierung wird daher kein eigener Maskierungsprozeß oder ähnliches benötigt.

Beim Einsatz moderner Belichtungsanlagen ist eine selbstjustierende Prozeßführung nicht zwingend notwendig, da die hohe Justiergenauigkeit ausreichend kleine Abstände zwischen Graben und Kontakt erlaubt. Der Kontakt wird durch die Isolationsschicht 54 hin bis in eine Tiefe des Siliziums geätzt, so daß, wie es bereits erwähnt wurde, gleichzeitig der Sourcebereich 46 und der Kanalbereich 44 offen liegen und kontaktiert werden können.

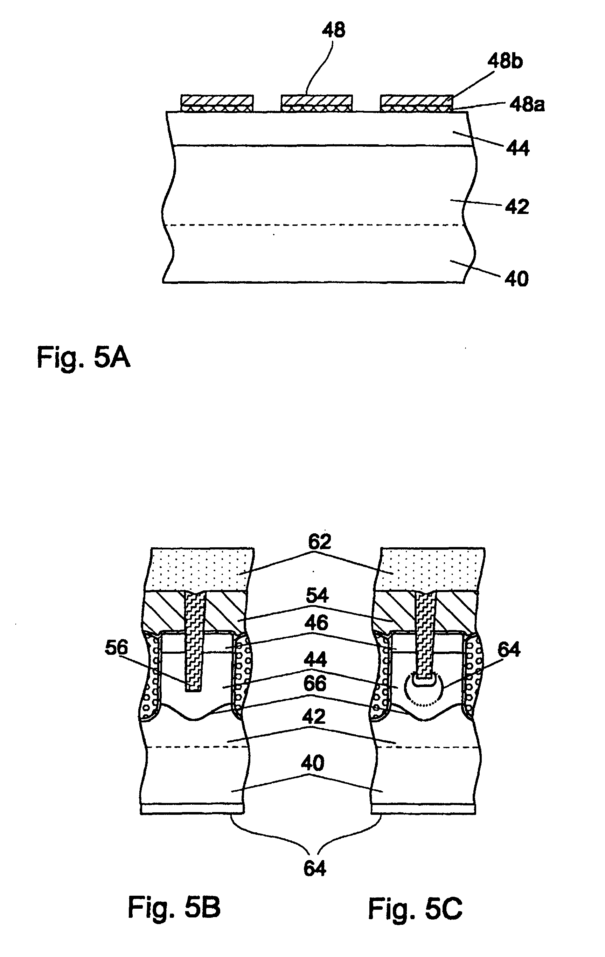

Die geöffneten Kontaktlöcher bilden vorteilhafterweise mit der sich noch auf der Waferoberfläche befindlichen Lackmaske vom Kontaktlochätzen eine selbstjustierende Maske für eine Kontaktlochimplantation 58 (Fig. 4D), die unter einem Implantationswinkel von 0° mit niedriger Energie ausgeführt wird. Diese Kontaktlochimplantation gewährleistet die für den industriellen Einsatz notwendige Robustheit durch Ausbildung eines niederohmigen Kontakts zwischen dem Sourcebereich 46 und dem Kanalbereich 44. In Fig. 5B und 5C werden weitere Möglichkeiten der Kontaktlochimplantation beschrieben. Es ist hervorzuheben, daß die Kontaktlochimplantation und die Ausbildung des feldformenden Dotierprofils ohne zusätzliche Phototechnik auskommen und zusätzlich selbstjustierend sind.

Fig. 4D zeigt das MOS-Leistungsbauelement, bei dem die Kontaktlöcher 56 (Fig. 4C) bereits aufgefüllt sind. Dieses Auffüllen der Kontaktlöcher erfolgt mit einer Metallisierung 60 die sich konform abscheiden läßt. Hierzu wird CVD-Wolfram verwendet. Alternativ kann auch CVD-Aluminium oder "Hot"-Aluminium verwendet werden. Hot-Aluminium ist Aluminium kurz vor dem Schmelzpunkt. Beim Einsatz von Wolfram wird die Verwendung einer Barriere aus Ti/TiN bevorzugt. Die verwendete Metallisierung kontaktiert den Kanalbereich 44 am Boden des Kontaktlochs 56 und den Sourcebereich 46 seitlich.

Anschließend wird eine Metallisierungsfläche 62 auf der gesamten Waferoberseite aufgebracht. Diese kann entweder eine reine Aluminiumschicht sein oder gemäß einem bevorzugten Ausführungsbeispiel der vorliegenden Erfindung eine Kombination aus Wolfram und Aluminium. Im ersteren Fall ist die Wolframschicht nach dem Auffüllen der Kontaktlöcher ganzflächig zurückzuätzen, so daß in den Kontaktlöchern sogenannte Wolframplugs stehen bleiben. Hierauf wird dann die zur niederohmigen Stromverteilung und für Bondverbindungen notwendige Aluminiumschicht gesputtert. Im letzteren Fall wird die Wolframschicht nicht zurückgeätzt, und die dicke Aluminiumschicht wird zusätzlich auf die Wolframschicht gesputtert. Die Wolframschicht dient in ihrer Eigenschaft als inertes Metall in Ergänzung zur Nitridschicht zur Passivierung der Scheibenoberflächen an Stellen, wo das Nitrid entfernt wurde.

Die dritte und letzte Phototechnik dient zur Strukturierung des Metalls in den Randbereichen des Transistors und in den Zwischenräumen zwischen dem großflächigen Sourceanschluß 20 und dem Gateanschluß 24. Nach einem Dünnen des Substrats auf der Scheibenrückseite wird eine geeignete lötfähige Rückseitenmetallisierung, z. B. ein Schichtsystem aus Ti/Ni/Ag, aufgebracht, um einen Drainkontakt 64 zu erzeugen.

In den Fig. 5A bis 5C sind einige Prozeßvarianten dargestellt. Fig. 5A zeigt den Fall, bei dem mittels der Maske 48 die Gräben erzeugt werden, bevor der Sourcebereich 46 (Fig. 4A) mittels Implantation erzeugt wird.

In Fig. 5B ist das Kontaktloch 56 sehr tief ausgeführt. In Fig. 5C ist das Kontaktloch nicht so tief ausgeführt, es wurden jedoch zusätzlich eine oder mehrere zusätzliche hochenergetische Implantationen in das Kontaktloch mit anschließender Ausdiffusion, wie es durch das Bezugszeichen 64 angedeutet ist, durchgeführt. Dadurch entsteht ein in den Fig. 5B und 5C dargestelltes gewissermaßen welliges Dotierprofil 66, wodurch eine feldformende Eigenschaft erhalten werden kann, wie sie in der WO 95/09439 beschrieben ist. Damit wird die Robustheit des Transistors weiter verstärkt. Es wird erneut darauf hingewiesen, daß diese weiteren Maßnahmen ohne zusätzliche Maskierungsschritte ausgeführt werden können, indem durch die Kontaktlöcher 56 die Kontaktierung des Source- und des Kanalbereichs durchgeführt werden.

Ein vertikales Leistungsbauelement mit einer Spannungsfestigkeit über 20 V sollte an seinen Rändern durch eine speziell ausgeformte Randstruktur begrenzt sein. Diese hat die Aufgabe, das elektrische Potential im Sperrbetrieb zur Seite hin abzubauen und die Raumladungszone so zu formen, daß es nicht zu Frühdurchbrüchen kommt, um so möglichst die Sperrspannung eines idealen pn-Übergangs zu erreichen. Übliche Formen der Randterminierung, wie sie insbesondere bei Hochvoltbauelementen eingesetzt werden, sind Feldringe, Feldplatten oder auch JTE- (JTE = Junction Termination Extension) Strukturen, die bisher durch lokale Implantationen mit zum Teil variierender Dotierung im Randbereich des Bauelements erzeugt wurden. Werden jedoch die Dotierschichten 42, 44, 46 ganzflächig erzeugt, ist es nicht möglich, Randstrukturen zu verwenden, die durch lokale Implantationen ausgebildet werden. In diesem Fall würde sich ohne zusätzliche Vorkehrungen die Raumladungszone über den eigentlichen Transistor hinaus bis zur Sägelinie des vereinzelten Transistors ausbreiten. Aufgrund der nicht idealen Kristalloberfläche an der Sägelinie kann es an dieser Sägekante zu Frühdurchbrüchen und Leckströmen kommen.

Um solche Effekte zu unterdrücken, werden Randterminierungsstrukturen eingesetzt, wie sie in den Fig. 6 und 7 dargestellt sind, die einen Querschnitt durch das MOS-Leistungsbauelement von Fig. 1 entlang der Linie B-B sind. Fig. 6 zeigt eine Randterminierungsstruktur mittels einer Mehrzahl von Terminierungsgräben 26, welche als floatende Ringe wirken und entlang einer Sägekante 68 angeordnet sind. Dieselben weisen einen nach außen zunehmenden Abschnitt auf, da somit eine bessere Feldformung erreicht wird. In Fig. 6 ist ferner die Kontaktierung des Anschlußgategrabens 22 über ein Kontaktloch dargestellt, das ebenso wie die Kontaktlöcher 56 (Fig. 4C) für den Source- und den Kanalbereich mittels des gleichen zweiten Photolithographieschritts erzeugt wird. Das Kontaktloch wird ebenso wie die Kontaktlöcher 56 mit dem Kontaktlochmetall 60 gefüllt, auf dem dann mittels des dritten photolithographischen Schritts der Gatekontakt 24 ausgebildet wird. Die gestrichelte Linie, die sich in Fig. 6 von dem Anschlußgategraben 22 nach links erstreckt, soll symbolisieren, daß hier der aktive Bereich des Transistors ist, bzw. daß von hier ausgehend sich die im wesentlichen parallelen aktiven Gategräben erstrecken, die durch den Anschlußgategraben 22 elektrisch miteinander verbunden werden.

Fig. 7 zeigt eine andere Alternative der Randterminierung, die einen feldplattenähnlichen Effekt erzeugt. Zur Orientierung ist in Fig. 7 wieder der Anschlußgategraben 22 dargestellt, an den sich rechts in Fig. 7 ein sehr großer Terminierungsgraben 26' anschließt, von dem nur der linke Bereich dargestellt ist. Derselbe ist bis zum Boden mit dem Zwischenoxid 54 bedeckt. Dies ist der Fall, da bei diesem Graben 26' aufgrund seiner hohen Breite beim Schritt des Rückätzens (zwischen Fig. 4B und Fig. 4C) das gesamte Polysilizium entfernt worden ist, jedoch bis auf die "Schulter" 52, die aus Polysilizium besteht. Dieses Polysilizium ist nach außen hin durch das Zwischenoxid isoliert und nach innen hin durch den Isolator 50. Dasselbe wird mittels eines eigenen Kontaktlochs 70 kontaktiert. Dieses Kontaktloch 70 wird ebenso wie ein weiteres Kontaktloch 72 im zweiten Photolithographieschritt erzeugt. Die beiden Kontaktlöcher werden durch eine Terminierungsmetallisierung 74 miteinander verbunden, derart, daß der Source- und der Kanalbereich mit dem Polysilizium 52, das am Rand des Terminierungsgrabens 26' verblieben ist, kurzgeschlossen werden, um eine "feldplattenartige" Struktur zu erzeugen, die für Spannungsklassen oberhalb 25 V eine ausreichende Spannungsfestigkeit liefert, damit die Sägekante 68 keinen ungünstigen Einfluß auf die Spannungsfestigkeit des Transistors nehmen kann.

Alternativ könnte die Polysiliziumschulter (Nr. 52 in Fig. 7) des Randterminierungsgrabens 26' floatend betrieben werden. In diesem Fall werden die Kontaktlöcher 70, 72 und die Terminierungsmetallisierung 74 nicht benötigt.

Grundsätzlich erlaubt das beschriebene Herstellungsverfahren erstmals einen vertikalen Leistungs-MOS-Transistor für den Niederspannungsbereich mit nur drei Lithographieschritten. Die Beschränkung auf drei Lithographieschritte ermöglicht eine Produktion des Transistors zu reduzierten Kosten, wobei die Prozeßkomplexität insbesondere auch durch die Verringerung der Gesamtanzahl der Prozeßschritte erniedrigt wird. Dadurch können Kosten vermieden werden und der Durchsatz kann gesteigert werden. Eine Reduzierung der Zahl der Prozeßschritte ermöglicht gleichzeitig insgesamt höhere Ausbeuten. Die so hergestellten Bauelemente eignen sich somit besonders für die kostenkritischen Massenmärkte, wie z. B. die Automobilindustrie oder den Consumer-Bereich.

Zur Übersicht wird nachfolgend ein detaillierter Ablaufplan zur Herstellung des Transistors gemäß einem Ausführungsbeispiel gegeben:
a) Oxidation (Schichtdicke: 1 - 100 nm, 28 nm);
b) Kanalimplantation (Energie: 150 - 360 keV, Dosis: 1E13 - 5E14⁻²) ;
c) Sourceimplantation (Energie: 120 - 180 keV; Dosis: 5E14 - 5E15cm⁻²);
d) 1. Phototechnik: Maskierung für den Trenchätzprozeß (Hartmaske: CVD-Oxid oder eine Kombination aus Nitrid und CVD-Oxid);
e) Trenche geeigneter Tiefe ätzen (Tiefe: 1 - 10 µm, 2,5 µm);
f) Reinigungsoxidation (Temperatur: ca. 1080°C, Komposition: trocken);
g) Entfernen des Reinigungsoxids;
h) gegebenenfalls zweite Reinigungsoxidation;
i) gegebenenfalls Entfernen des zweiten Reinigungsoxids;
j) Gateoxidation (Dicke: 28 - 120 nm);
k) Auffüllen der Trenche mit dotiertem Polysilizium oder in zwei oder mehreren Schichten mit anschließender POCL₃-Belegung oder mit Wolfram auf dünner Polysiliziumschicht und anschließender Silizidierung;
l) ganzflächiges Rückätzen des Polysiliziums (Wolframs) oder Abtragen mit CMP (CMP = Chemical Mechanical Planarisation);
m) Abscheiden eines Zwischenoxids;
n) 2. Phototechnik: Strukturierung der Kontaktlöcher;
o) Ätzen der Kontaktlöcher bis zu einer geeigneten Tiefe (gleichzeitige Kontaktierung von Source und Kanal);
p) gegebenenfalls Kontaktlochimplantation zur Verbesserung des Kontakts und zur Ausbildung der Avalanche-Schutzstruktur;
q) Ausheilen und -diffundieren der Implantation (Temperatur: 900 - 1100°C, Zeit: 10 sec - 30 min);
r) Aufbringen einer Barriere (Titan/Titannitrid (Ti/TiNi); Dicke 50 - 150 nm);
s) Verfüllen der Kontaktlöcher mit Wolfram;
t) ganzflächiges Rückätzen des Wolframs (a) oder optional Wolfram als leitfähige Schicht stehen lassen (b);
u) Aufbringen einer dicken Alu- oder Kupfermetallisierung; kann entfallen, wenn gemäß Schritt t), Alternative (b) Wolfram nicht rückgeätzt wird;
v) 3. Phototechnik: Strukturierung der Metallisierung;
w) Naß- oder Plasmastrukturierung des Aluminiums;
x) gegebenenfalls Rückschleifen der Wafer; und
y) Aufbringen einer lötfähigen Rückseitenmetallisierung.

Das erfindungsgemäße Herstellungsverfahren liefert folgende Vorteile:

Wie es bereits erwähnt wurde, ist das Herstellungsverfahren auf lediglich drei Masken beschränkt.

Weiterhin wird das Source/Kanal-Gebiet gleichzeitig mit der Kontaktierung der Anschlußgategräben bewirkt.

Weiterhin erfolgt die Gatekontaktierung über ein Kontaktloch (Langloch), das auf einem speziellen Graben, d. h. dem Anschlußgategraben, justiert und im selben Prozeßschritt geätzt wird, wie die zur Source- und Kanalkontaktierung verwendeten Kontaktlöcher. Vorzugsweise wird der Anschlußgategraben breiter als die aktiven Gategräben gewählt, um eine sichere Positionierung des Kontaktlochs für die Gatekontaktierung zu erreichen.

Weiterhin kann erreicht werden, daß die aktiven Gategräben unter einem geeigneten Winkel in den Gateanschlußgraben münden. Bei dem in den Fig. 1 und 3 gezeigten Ausführungsbeispiel beträgt dieser Winkel 90°. Bei dem in Fig. 2 gezeigten

Ausführungsbeispiel beträgt der spitze Winkel 45°.

Alternativ könnten die aktiven Gategräben, bevor sie auf den Gateanschlußgraben auftreffen, modifiziert werden, daß sie wieder in einem Winkel von 90° auf den Gateanschlußgraben auftreffen. Diese Modifikation würde in einer Einfügung von Knicken oder Kurven in die aktiven Gategräben bestehen. Der Winkel von 90° hat den Vorteil, daß gewissermaßen kein spitzer Winkel auftritt.

Die Ausbildung der Randterminierung des Transistors erfolgt parallel zur Ausbildung der aktiven Gategräben, des Anschlußgategrabens und der Kontaktlöcher. Die Randterminierung kann dabei entweder aus einer feldplattenähnlichen Konstruktion oder aus einer oder mehreren rundumlaufenden Gräben mit an die Sperrspannungsklasse angepaßten Abständen bestehen. Dies kann ohne Verwendung einer zusätzlichen Maske für die Randterminierung erreicht werden.

Weiterhin kann auf eine abschließende Passivierung verzichtet werden, da bereits eine Passivierung durch die Wolframschicht auf dem Zwischenoxid erreicht wird, da ein Zwischenoxid als Schichtsystem aus Oxid und Nitrid verwendet wird, da eine Passivierung durch eine Ti/TiN-Barriere verwendet werden kann, und da ein Zwischenoxid aus verdichtetem Silanoxid eingesetzt wird, das eine hervorragende passivierende Wirkung hat. Außerdem ist eine selbstjustierende Kontaktlochimplantation realisiert, da die Maske für das Kontaktlochätzen und das geätzte Zwischenoxid als Maskierung für die Kontaktlochimplantation dienen.

Ohne einen zusätzlichen Lithographieschritt wird ein robustes Transistorkonzept mit hoher Avalanchfestigkeit erreicht, indem die Randterminierungsstruktur ohne einen zusätzlichen Lithographieschritt parallel zur Ausbildung des aktiven Bereichs erzeugt wird.

Schließlich kann auf lokale p- oder n-dotierte Bereiche verzichtet werden, da der erforderlich Dotierstoffverlauf preisgünstig und einfach entweder durch ganzflächige Implantation und/oder durch Epitaxieeschichten erzeugt wird.

Eine typische Ausführungsform der vorliegenden Erfindung hat folgende Abmessungen:

| Struktur | Abmessungen (µm) |
|---|---|
| Transistor | 1000*1000 - 55000*55000 |
| Grabenweite | 0,4 - 0,8 |
| Zellpitch (Wiederholmaß) | 1,8 - 3,0 |
| Kontaktloch | 0,4 - 0,8 |
| Breite Gräben (Randstruktur) | 2 - 10 |
| Abstände floatende Gräben | 0,4 - 0,8 |
| Grabentiefe | 1,5 - 3,5 |

## Patentansprüche

1. MOS-Leistungsbauelement mit folgenden Merkmalen:
einem Driftbereich (42) mit einer Dotierung eines ersten Dotierungstyps;
einem Kanalbereich (44) mit einer Dotierung eines zweiten Dotierungstyps, wobei der zweite Dotierungstyp komplementär zu dem ersten Dotierungstyp ist, und wobei der Kanalbereich (44) an den Driftbereich (42) angrenzt;
einem Sourcebereich (46) mit einer Dotierung des ersten Dotierungstyps, wobei der Sourcebereich (46) an den Kanalbereich (44) angrenzt;
einer Sourcekontaktstruktur (20, 60) zur Kontaktierung des Sourcebereichs (46); und
einer Kanalkontaktstruktur (20, 60) zur Kontaktierung des Kanalbereichs (44);
**gekennzeichnet durch**
eine Mehrzahl von im wesentlichen parallelen, voneinander beabstandeten Gategräben (12), die einen aktiven Bereich des MOS-Leistungsbauelements definieren und sich **durch** den Sourcebereich (46), den Kanalbereich (44) und in den Driftbereich (42) hinein erstrecken, wobei die Gategräben elektrisch leitfähiges Material (52) aufweisen, das **durch** einen Isolator (50) von dem Sourcebereich (46), dem Kanalbereich (44) und dem Driftbereich (42) elektrisch isoliert ist;
einen Anschlußgategraben (22) zum elektrisch leitfähigen Verbinden der Gategräben (12), der sich **durch** den Sourcebereich (46), den Kanalbereich (44) und in den Driftbereich (42) hinein erstreckt, wobei der Anschlußgategraben (22) elektrisch leitfähiges Material (52) aufweist, das **durch** einen Isolator (50) von dem Sourcebereich (46), dem Kanalbereich (44) und dem Driftbereich (42) elektrisch isoliert ist, wobei der Anschlußgategraben (22) ein umlaufender Graben ist, der einen ersten Verbindungsbereich (22a), einen zweiten Verbindungsbereich, einen ersten Längsbereich (22b) und einen zweiten Längsbereich aufweist, wobei der erste Verbindungsbereich (22a) erste Enden der Mehrzahl von Gategräben (12) miteinander verbindet, wobei der zweite Verbindungsbereich zweite Enden der Mehrzahl von Gategräben (12) miteinander verbindet, und wobei der erste und der zweite Längsbereich (22b) den ersten und den zweiten Verbindungsbereich (22a) miteinander verbinden, derart, daß das aktive Gebiet, das **durch** die Mehrzahl von Gategräben (12) definiert ist, von dem Anschlußgategraben (22) vollständig umschlossen ist; und
einen Gatekontakt (24) zur Kontaktierung des Anschlußgategrabens (22), wobei der Gatekontakt (24) über ein mit elektrisch leitfähigem Material (60) gefülltes Kontaktloch (56) **durch** den Isolator (50) des Anschlußgategrabens mit dem elektrisch leitfähigen Material (52) des Anschlußgategrabens (22) verbunden ist.

2. MOS-Leistungsbauelement mit folgenden Merkmalen:
einem Driftbereich (42) mit einer Dotierung eines ersten Dotierungstyps;
einem Kanalbereich (44) mit einer Dotierung eines zweiten Dotierungstyps, wobei der zweite Dotierungstyp komplementär zu dem ersten Dotierungstyp ist, und wobei der Kanalbereich (44) an den Driftbereich (42) angrenzt;
einem Sourcebereich (46) mit einer Dotierung des ersten Dotierungstyps, wobei der Sourcebereich (46) an den Kanalbereich (44) angrenzt;
einer Sourcekontaktstruktur (20, 60) zur Kontaktierung des Sourcebereichs (46); und
einer Kanalkontaktstruktur (20, 60) zur Kontaktierung des Kanalbereichs (44);
**gekennzeichnet durch**
eine Mehrzahl von im wesentlichen parallelen, voneinander beabstandeten Gategräben (12), die einen aktiven Bereich des MOS-Leistungsbauelements definieren und sich **durch** den Sourcebereich (46), den Kanalbereich (44) und in den Driftbereich (42) hinein erstrecken, wobei die Gategräben elektrisch leitfähiges Material (52) aufweisen, das **durch** einen Isolator (50) von dem Sourcebereich (46), dem Kanalbereich (44) und dem Driftbereich (42) elektrisch isoliert ist;
einen Anschlußgategraben (22) zum elektrisch leitfähigen Verbinden der Gategräben (12), der sich **durch** den Sourcebereich (46), den Kanalbereich (44) und in den Driftbereich (42) hinein erstreckt, wobei der Anschlußgategraben (22) elektrisch leitfähiges Material (52) aufweist, das **durch** einen Isolator (50) von dem Sourcebereich (46), dem Kanalbereich (44) und dem Driftbereich (42) elektrisch isoliert ist, wobei der Anschlußgategraben (22) einen umlaufenden Abschnitt (22a), der einen nicht-aktiven Bereich des MOS-Leistungsbauelements umschließt, in dem sich keine Gategräben befinden, und mit dem umlaufenden Abschnitt elektrisch leitfähig verbundene Auslegerabschnitte aufweist, die zumindest einen Teil der Gategräben elektrisch leitfähig miteinander verbinden; und
einen Gatekontakt (24) zur Kontaktierung des Anschlußgategrabens (22), wobei der Gatekontakt (24) über ein mit elektrisch leitfähigem Material (60) gefülltes Kontaktloch (56) **durch** den Isolator (50) des Anschlußgategrabens mit dem elektrisch leitfähigen Material (52) des Anschlußgategrabens (22) verbunden ist.

3. MOS-Leistungsbauelement nach Anspruch 1 oder 2, bei dem die Breite des Anschlußgategrabens (22) zur Aufnahme des Kontaktlochs (56) größer als die Breite eines der Mehrzahl von Gategräben (12) ist.

4. MOS-Leistungsbauelement nach einem der vorhergehenden Ansprüche, bei dem der Winkel zwischen einem der Mehrzahl von Gategräben (12) und dem Anschlußgategraben (22) im wesentlichen 90½ beträgt.

5. MOS-Leistungsbauelement nach einem der Ansprüche 1, 3 oder 4, bei dem der Gatekontakt (24) an einem Rand (68) des MOS-Leistungsbauelements angeordnet ist und sich nur teilweise über einen aktiven Bereich des MOS-Leistungsbauelements erstreckt.

6. MOS-Leistungsbauelement nach einem der Ansprüche 2 bis 4, bei dem der Gatekontakt (24) im wesentlichen in der Mitte des MOS-Leistungsbauelements angeordnet ist und sich höchstens teilweise oder überhaupt nicht über einen aktiven Bereich des MOS-Leistungsbauelements erstreckt.

7. MOS-Leistungsbauelement nach einem der Ansprüche 2 bis 4 oder 6, bei dem der umlaufende Abschnitt (22a) des Anschlußgategrabens zwei Verbindungsbereiche aufweist, die im wesentlichen senkrecht zu den Gategräben angeordnet sind, wobei die Auslegerabschnitte (22c bis 22f) in derselben Richtung wie die Verbindungsbereiche ausgerichtet sind.

8. MOS-Leistungsbauelement nach einem der Ansprüche 2 bis 4, 6 oder 7, das eine rechteckige Form aufweist, wobei die Mehrzahl von Gategräben (12) vier Untergruppen aufweist, wobei die Gategräben (12) jeder Untergruppe zu je einem Rand des MOS-Leistungsbauelements parallel sind und wobei die Auslegerabschnitte des Anschlußgategrabens (22) jeweils diagonal zu den Vierecken des MOS-Leistungsbauelements in Richtung des umlaufenden Anschlußgategrabens (22) verlaufen, um die Gategräben elektrisch leitfähig miteinander zu verbinden.

9. MOS-Leistungsbauelement nach einem der vorhergehenden Ansprüche, das ferner eine Randterminierungsstruktur (26) aufweist, die einen aktiven Bereich des MOS-Leistungsbauelements vollständig umgibt.

10. MOS-Leistungsbauelement nach Anspruch 9, bei dem die Randterminierungsstruktur eine Mehrzahl von parallel verlaufenden Terminierungsgräben (26a, 26b) aufweist, die nicht kontaktiert sind, und deren Abstände untereinander zum Rand des MOS-Leistungsbauelements zunehmen, um eine bestimmte Sperrspannungsklasse zu erfüllen.

11. MOS-Leistungsbauelement nach Anspruch 9, bei dem die Randterminierungsstruktur einen Teil eines Terminierungsgrabens (26') aufweist, der an seinem Rand gegenüber dem Sourcebereich, dem Drainbereich und dem Kanalbereich durch einen Isolator (50) isoliertes leitfähiges Material (52) aufweist, wobei das leitfähige Material (52) der Randterminierungsstruktur über ein Kontaktloch (70), eine Oberseitenmetallisierung (74) und ein Kontaktloch (72) mit dem Sourcebereich (46) und dem Drainbereich (44) elektrisch leitfähig verbunden ist,
wobei der Rand (68) des MOS-Leistungsbauelements in dem Terminierungsgraben (26') verläuft.

12. MOS-Leistungsbauelement nach einem der vorhergehenden Ansprüche, bei dem die Sourcekontaktstruktur und die Kanalkontaktstruktur ein gemeinsames, mit elektrisch leitfähigem Material (60) gefülltes Kontaktloch (56) aufweisen, das sich durch den Sourcebereich (46) und in den Kanalbereich (44) hinein erstreckt, derart, daß der Sourcebereich (46) und der Kanalbereich (44) mittels eines einzigen Kontakts auf dem gleichen Potential gehalten werden können.

13. MOS-Leistungsbauelement nach einem der vorhergehenden Ansprüche, bei dem der Driftbereich (42), der Kanalbereich (44) und der Sourcebereich (46) flächige Schichten auf einer stark dotierten Substratschicht (40) mit einer Dotierung des ersten Dotierungstyps sind.

14. MOS-Leistungsbauelement nach einem der Ansprüche 1 bis 12, bei dem der Driftbereich (42), der Kanalbereich (44) und der Sourcebereich (46) flächige Schichten auf einer stark dotierten Substratschicht mit einer Dotierung des ersten Dotierungstyps sind.

15. MOS-Leistungsbauelement nach Anspruch 12, bei dem die Grenze zwischen dem Kanalbereich und dem Sourcebereich aufgrund einer Kontaktlochimplantation (66) durch das Kontaktloch (56) nicht zu einer Hauptoberfläche des MOS-Leistungsbauelements parallel ist.

16. Verfahren zum Herstellen eines MOS-Leistungsbauelements nach Anspruch 1 oder 2, mit folgenden Schritten:
Bereitstellen eines Substrats mit einem Driftbereich (42) mit einer Dotierung eines ersten Dotierungstyps, einem Kanalbereich (44) mit einer Dotierung eines zweiten Dotierungstyps, wobei der zweite Dotierungstyp komplementär zu dem ersten Dotierungstyp ist, und wobei der Kanalbereich (44) an den Driftbereich (42) angrenzt, und eines Sourcebereichs (46) mit einer Dotierung des ersten Dotierungstyps, wobei der Sourcebereich (46) an den Kanalbereich (44) angrenzt; photolithographisches Erzeugen (48) von im wesentlichen parallelen, voneinander beabstandeten Gategräben (12), die einen aktiven Bereich des MOS-Leistungsbauelements definieren und eines Anschlußgategrabens (22), durch den die Mehrzahl von im wesentlichen parallelen Gategräben (12) elektrisch leitfähig miteinander verbindbar ist, derart, daß dieselben sich durch den Sourcebereich (46), den Kanalbereich (44) und in den Driftbereich (42) hinein erstrecken,
wobei der Anschlußgategraben (22) ein umlaufender Graben ist, der einen ersten Verbindungsbereich (22a), einen zweiten Verbindungsbereich, einen ersten Längsbereich (22b) und einen zweiten Längsbereich aufweist, wobei der erste Verbindungsbereich (22a) erste Enden der Mehrzahl von Gategräben (12) miteinander verbindet, wobei der zweite Verbindungsbereich zweite Enden der Mehrzahl von Gategräben (12) miteinander verbindet, und wobei der erste und der zweite Längsbereich (22b) den ersten und den zweiten Verbindungsbereich (22a) miteinander verbinden, derart, daß das aktive Gebiet, das durch die Mehrzahl von Gategräben (12) definiert ist, von dem Anschlußgategraben (22) vollständig umschlossen ist; oder wobei der Anschlußgategraben (22) einen umlaufenden Abschnitt (22a), der einen nicht-aktiven Bereich des MOS-Leistungsbauelements umschließt, in dem sich keine Gategräben befinden, und mit dem umlaufenden Abschnitt elektrisch leitfähig verbundene Auslegerabschnitte aufweist, die zumindest einen Teil der Gategräben elektrisch leitfähig miteinander verbinden;
Bearbeiten der Gategräben (12) und des Anschlußgategrabens (22), damit sie leitfähiges Material (52) aufweisen, das durch einen Isolator (50) von dem Sourcebereich (46), dem Kanalbereich (44) und dem Driftbereich (42) getrennt ist;
photolithographisches Erzeugen von Kontaktlöchern (56) zur Kontaktierung des Sourcebereichs (46), des Kanalbereichs (44) und des Anschlußgategrabens (22), wobei der Anschlußgategraben (22) über die Kontaktlöcher, die dem Anschlußgategraben (22) zugeordnet sind, kontaktierbar ist;
Füllen der Kontaktlöcher (26) mit einem elektrisch leitfähigen Material (60); und
photolithographisches Erzeugen des Gatekontakts (24), des Sourcekontakts (20) und des Kanalkontakts (20).

17. Verfahren nach Anspruch 16, bei dem die Schritte des photolithographischen Erzeugens jeweils einen Schritt des Herstellens einer Maske und einen Schritt des Ätzens bis zu einer spezifizierten Tiefe aufweist.

18. Verfahren nach Anspruch 16 oder 17, bei dem der Schritt des Bereitstellens folgende Schritte aufweist:
Implantieren eines Kanalbereichs (44) in ein Halbleitersubstrat, das mit dem ersten Dotierungstyp dotiert ist; und
Implantieren des Sourcebereichs (46) in das Halbleitersubstrat.

19. Verfahren nach Anspruch 16 oder 17, bei dem der Schritt des Bereitstellens eines Substrats folgende Schritte aufweist:
epitaktisches Aufwachsen des Kanalbereichs (44) auf ein Halbleitersubstrat;
Implantieren des Sourcebereichs (46) in den epitaktisch aufgewachsenen Kanalbereich (44).

20. Verfahren nach einem der Ansprüche 16 bis 19, bei dem nach dem Schritt des photolithographischen Erzeugens der Gategräben (12) und des Anschlußgategrabens (22) zumindest eine Reinigungsoxidation mit anschließender Entfernung des Reinigungsoxids durchgeführt wird.

21. Verfahren nach einem der Ansprüche 16 bis 20, bei dem der Schritt des Bearbeitens der Gategräben (12) und des Anschlußgategrabens (22) folgende Schritte aufweist:
Durchführen einer Gateoxidation, um den Isolator (50) zu erzeugen;
Auffüllen der oxidierten Gräben mit dem leitfähigen Material (52);
Entfernen von leitfähigem Material, derart, daß nur das leitfähige Material in den Gräben verbleibt; und
Aufbringen eines Zwischenoxids (54).

22. Verfahren nach Anspruch 21, bei dem das Zwischenoxid (54) dotierte oder undotierte CVD-Oxide, wie z. B. Bor-Phosphor-Silikatglas (BPSG), oder Silanoxid oder Kombinationen aus Oxid und Nitrid aufweist.

23. Verfahren nach einem der Ansprüche 16 bis 22, bei dem im Schritt des photolithographischen Erzeugens und des Bearbeitens der Gategräben (12) und des Anschlußgategrabens (22) zumindest ein Terminierungsgraben (26) erzeugt wird, der um einen aktiven Bereich des MOS-Leistungsbauelements herum verläuft, der durch die Mehrzahl von Gategräben und den Anschlußgategraben (22) festgelegt ist.

24. Verfahren nach einem der Ansprüche 16 bis 23, bei dem nach dem photolithographischen Erzeugen der Kontaktlöcher (56) eine Kontaktlochimplantation (64) ausgeführt wird, um einen niederohmigen Kontakt zu dem Kanalbereich (44) zu ermöglichen.

25. Verfahren nach einem der Ansprüche 16 bis 24, bei dem nach dem Schritt des photolithographischen Erzeugens der Kontaktlöcher eine weitere Kontaktlochimplantation (66) durchgeführt wird, um das Dotierprofil des Kanalbereichs (44) und des Driftbereichs (42) zu modifizieren.

26. Verfahren nach einem der Ansprüche 16 bis 25, bei dem die Kontaktlöcher (56) mit leitfähigem Material (60) aufgefüllt werden, wodurch das Sourcegebiet (46) und das Kanalgebiet (44) kurzgeschlossen werden und der Anschlußgategraben (22) kontaktiert wird.

27. Verfahren nach einem der Ansprüche 16 bis 26, bei dem vor dem photolithographischen Erzeugen des Gatekontakts (24), des Source- und des Kanalkontakts (20) eine ganzflächige Metallschicht (62) aufgebracht wird, die Wolfram, Aluminium oder eine Kombination aus Wolfram und Aluminium aufweist.

28. Verfahren nach einem der Ansprüche 16 bis 27, bei dem im Schritt des photolithographischen Erzeugens des Gatekontakts (24), des Sourcekontakts und des Kanalkontakts (20) ein Sourcekontakt (20) erzeugt wird, der sich im wesentlichen über die gesamte Oberfläche des MOS-Leistungsbauelements erstreckt, mit Ausnahme eines Bereichs um den Anschlußgategraben (22) herum, in dem sich der Gatekontakt (24) befindet.

29. Verfahren nach einem der Ansprüche 23 bis 28, bei dem im Schritt des photolithographischen Erzeugens und Bearbeitens der Gategräben (12) und des Anschlußgategrabens (22) eine Mehrzahl von Terminierungsgräben (26) erzeugt wird, die nicht kontaktiert sind, und deren gegenseitiger Abstand zum Rand des MOS-Leistungsbauelements zunimmt.

30. Verfahren nach einem der Ansprüche 23 bis 28, bei dem der Terminierungsgraben eine Breite aufweist, die 5 bis 25 mal so groß ist wie die Breite eines Gategrabens (12), und bei dem im Schritt des photolithographischen Erzeugens von Kontaktlöchern ein Kontaktloch (72) in den Sourcebereich (46) und den Kanalbereich (44) neben dem Terminierungsgraben (26') und in ein elektrisch leitfähiges Material (52) am Rand des Terminierungsgrabens (26') erzeugt wird, und bei dem im Schritt des photolithographischen Erzeugens des Gatekontakts (24), der Source- und des Kanalkontakts (22) eine metallische Verbindung (74) zwischen dem Kontaktloch (70) in dem Terminierungsgraben (26') und dem Kontaktloch (72) in dem Sourcebereich (46) und dem Kanalbereich (44) erzeugt wird, um eine feldplattenähnliche Struktur zu erzeugen.

31. Verfahren nach einem der Ansprüche 28 bis 30, bei dem der Anschlußgategraben, der Sourcekontakt (20) und der Gatekontakt (24) derart angeordnet werden, daß sich der Gatekontakt (24) im wesentlichen in der Mitte des MOS-Leistungsbauelements befindet.

32. Verfahren nach Anspruch 16 oder 17, bei dem der Schritt des Bearbeitens der Gategräben (12) folgende Teilschritte aufweist:
Erzeugen eines Gateoxids (50) in den Gategräben (12);
Aufbringen einer Schicht aus Polysilizium auf das Gateoxid (50);
Aufbringen von Wolfram auf das Polysilizium;
thermisches Behandeln der Anordnung, derart, daß eine Silizidierung stattfindet.

33. Verfahren nach Anspruch 16 oder 17,
bei dem der Schritt des Bereitstellens folgende Schritte aufweist:
Implantieren eines Kanalbereichs (44) in ein Halbleitersubstrat, das mit dem ersten Dotierungstyp dotiert ist; und
Implantieren des Sourcebereichs (46) in das Halbleitersubstrat.
und das nach dem Schritt des photolithographischen Erzeugens des Gatekontakts (24), des Sourcekontakts (20) und des Kanalkontakts (20) ferner folgende Schritte aufweist:
Rückschleifen des Halbleitersubstrats auf der Seite, die der Seite gegenüberliegt, in der die Gategräben (12) gebildet sind;
Implantieren eines hoch dotierten Bereichs in das Halbleitersubstrat von der Seite aus, die rückgeschliffen ist; und
Aufbringen einer Rückseitenmetallisierung, um einen Drainkontakt herzustellen.

## Claims

1. Power MOS element comprising:
a drift region (42) with a doping of a first doping type;
a channel region (44) with a doping of a second doping type, said second doping type being complementary to said first doping type, and said channel region (44) bordering on said drift region (42);
a source region (46) with a doping of said first doping type, said source region (46) bordering on said channel region (44);
a source contact structure (20, 60) for contacting said source region (46); and
a channel contact structure (20, 60) for contacting said channel region (44);
**characterized by**
a plurality of essentially parallel gate trenches (12) spaced from one another defining an active region of said power MOS element and extending through said source region (46), said channel region (44) and into said drift region (42), said gate trenches comprising an electrically conductive material (52) which is electrically insulated from said source region (46), said channel region (44) and said drift region (42) by an insulator (50);
a connecting gate trench (22) for connecting the gate trenches (12) in an electrically conductive way, extending through said source region (46), said channel region (44) and into said drift region (42), said connecting gate trench (22) comprising an electrically conductive material (52) which is electrically insulated from said source region (46), said channel region (44) and said drift region (42) by an insulator (50), said connecting gate trench (22) being a circumferential trench comprising a first connecting region (22a), a second connecting region, a first longitudinal region (22b) and a second longitudinal region, said first connecting region (22a) connecting first ends of said plurality of gate trenches (12) to one another, said second connecting region connecting second ends of said plurality of gate trenches (12) to one another, and said first and said second longitudinal regions (22b) connecting said first and said second connecting regions (22a) to each other in such a way that the active region which is defined by said plurality of gate trenches (22) is completely surrounded by said connecting gate trench (22); and
a gate contact (24) for contacting said connecting gate trench (22), said gate contact (24) being connected via a contact hole through said insulator (50) of said connecting gate trench which is filled with an electrically conductive material (60) to said electrically conductive material (52) of said connecting gate trench (22).

2. Power MOS element comprising:
a drift region (42) with a doping of a first doping type;
a channel region (44) with a doping of a second doping type, said second doping type being complementary to said first doping type, and said channel region (44) bordering on said drift region (42);
a source region (46) with a doping of said first doping type, said source region (46) bordering on said channel region (44);
a source contact structure (20, 60) for contacting said source region (46); and
a channel contact structure (20, 60) for contacting said channel region (44);
**characterized by**
a plurality of essentially parallel gate trenches (12) spaced from one another defining an active region of the power MOS element and extending through said source region (46), said channel region (44) and into said drift region (42), said gate trenches comprising an electrically conductive material (52) which is electrically insulated from said source region (46), said channel region (44) and said drift region (42) by an insulator (50);
a connecting gate trench (22) for connecting the gate trenches (12) in an electrically conductive way, extending through said source region (46), said channel region (44) and into said drift region (42), said connecting gate trench (22) comprising an electrically conductive material (52) which is electrically insulated from said source region (46), said channel region (44) and said drift region (42) by an insulator (50), said connecting gate trench (22) comprising a circumferential section (22a) surrounding a non-active region of said power MOS element, in which there are no gate trenches, and extension sections connected in an electrically conductive way to said circumferential section, said extension sections connecting at least a part of the gate trenches to one another in an electrically conductive way; and
a gate contact (24) for contacting said connecting gate trench (22), said gate contact (24) being connected via a contact hole through said insulator (50) of said connecting gate trench which is filled with an electrically conductive material (60) to said electrically conductive material (52) of said connecting gate trench (22).

3. Power MOS element according to claim 1 or 2, wherein the width of said connecting gate trench (22) for receiving said contact hole (56) is larger than the width of one of said plurality of gate trenches (12).

4. Power MOS element according to one of the preceding claims, wherein the angle between one of said plurality of gate trenches (12) and said connecting gate trench (22) is essentially 90°.

5. Power MOS element according to one claims 1, 3 or 4, wherein said gate contact (24) is located at a margin (68) of said power MOS element and only extends partly over an active region of said power MOS element.

6. Power MOS element according to on of claims 2 to 4, wherein said gate contact (24) is located essentially in the middle of said power MOS element and extends at most partly, if not not at all, over an active region of said power MOS element.

7. Power MOS element according to one of claims 2 to 4 or 6, wherein said circumferential section (22a) of said connecting gate trench comprises two connecting regions which are substantially arranged perpendicularly to said gate trenches, said extension sections (22c - 22f) being oriented in the same direction as the connecting regions.

8. Power MOS element according to one of claims 2 to 4, 6 or 7, having a rectangular form, said plurality of gate trenches (12) comprising four subgroups, said gate trenches (12) of each subgroup being parallel to a margin of said power MOS element each, and said extension sections of said connecting gate trench (22) each extending diagonally to said rectangles of said power MOS element in the direction of said circumferential connecting gate trench (22) to connect said gate trenches to one another in an electrically conductive way.

9. Power MOS element according to one of the preceding claims, further comprising a margin terminating structure (26) completely surrounding an active region of said power MOS element.

10. Power MOS element according to claim 9, wherein said margin terminating structure comprises a plurality of parallel terminating trenches (26a, 26b) which are not contacted and whose distances between one another increase towards the margin of said power MOS element to fulfil a certain reverse voltage class.

11. Power MOS element according to claim 9, wherein said margin terminating structure comprises a part of a terminating trench (26') which comprises, at its margin opposite to said source region, said drain region and said channel region, a conductive material (52) insulated by an insulator (50), said conductive material (52) of said margin terminating structure being connected in an electrically conductive way to said source region (46) and said drain region (44) via a contact hole (70), an upper side metalization (74) and a contact hole (72), said margin (68) of said power MOS element extending in said terminating trench (26').

12. Power MOS element according to one of the preceding claims, wherein said source contact structure and said channel contact structure comprise a common contact hole (56) filled with an electrically conductive material (60), said contact hole extending through said source region (46) and into said channel region (44) in such a way that said source region (46) and said channel region (44) can be held at the same potential by means of a single contact.

13. Power MOS element according to one of the preceding claims, wherein said drift region (42), said channel region (44) and said source region (46) are planar layers on a strongly doped substrate layer (40) with a doping of said first doping type.

14. Power MOS element according to one of claims 1 to 12, wherein said drift region (42), said channel region (44) and said source region (46) are planar layers on a strongly doped substrate layer with a doping of said first doping type.

15. Power MOS element according to claim 12, wherein the margin between said channel region and said source region, due to a contact hole implantation (66) through said contact hole (56), is not parallel to a main surface of said power MOS element.

16. Method for producing a power MOS element according to claim 1 or 2, comprising the following steps:
providing a substrate having a drift region (42) with a doping of a first doping type, a channel region (44) with a doping of a second doping type, said second doping type being complementary to said first doping type and said channel region (44) bordering on said drift region (42), and a source region (46) with a doping of said first doping type, said source region (46) bordering on said channel region (44);
photolithographic producing (48) of essentially parallel gate trenches (12) spaced from one another defining an active region of the power MOS element, and of a connecting gate trench (22) by means of which said plurality of essentially parallel gate trenches (12) is connectable to one another in an electrically conductive way in such a way that said gate trenches extend through said source region (46), said channel region (44) and into said drift region (42)
wherein said connecting gate trench (22) being a circumferential trench comprising a first connecting region (22a), a second connecting region, a first longitudinal region (22b) and a second longitudinal region, said first connecting region (22a) connecting first ends of said plurality of gate trenches to one another, said second connecting gate trench connecting second ends of said plurality of gate trenches (12) to one another, and said first and said second longitudinal regions (22b) connecting said first and said second connecting regions (22a) to one another in such a way that the active region which is defined by said plurality of gate trenches (22) is completely surrounded by said connecting gate trench (22); or wherein said connecting gate trench (22) comprising a circumferential section (22a) surrounding a non-active region of said power MOS element, in which there are no gate trenches, and extension sections being connected to said circumferential section in an electrically conductive way, said extension sections connecting at least a part of said gate trenches to one another in an electrically conductive way;
processing said gate trenches (12) and said connecting gate trench (22) in order to comprise a conductive material (52) which is isolated from said source region (46), said channel region (44) and said drift region (42) by an insulator (50);
photolithographic producing of contact holes (56) for contacting said source region (46), said channel region (44) and said connecting gate trench (22), said connecting gate trench (22) being contactable via said contact holes associated to said connecting gate trench (22);
filling said contact holes (26) with an electrically conductive material (60); and
photolithographic producing of said gate contact (24), said source contact (20) and said channel contact (20).

17. Method according to claim 16, wherein the steps of photolithographic producing each comprise a step of producing a mask and a step of etching to a specific depth.

18. Method according to claim 16 or 17, wherein the step of providing comprises the following steps:
implanting a channel region (44) into a semiconductor substrate which is doped with said first doping type; and
implanting said source region (46) into said semiconductor substrate.

19. Method according to claim 16 or 17, wherein the step of providing a substrate comprises the following steps:
epitaxial growing of said channel region (44) onto a semiconductor substrate;
implanting said source region (46) into said epitaxially grown channel region (44).

20. Method according to one of claims 16 to 19, wherein, after the step of the photolithographic producing of said gate trenches (12) and said connecting gate trench (22), at least one purification oxidation with subsequent removal of said purification oxide is carried out.

21. Method according to one of claims 16 to 20, wherein the step of processing said gate trenches (12) and said connecting gate trench (22) comprises the following steps:
carrying out a gate oxidation to produce said insulator (50);
filling said oxidized trenches with said conductive material (52);
removing conductive material in such a way that only said conductive material remains in said trenches; and
depositing an intermediate oxide (54).

22. Method according to claim 21, wherein said intermediate oxide (54) comprises doped or undoped CVC-oxides, such as boron phosphorus silicate glass (BPSG) or silane oxide or combinations of oxide and nitride.

23. Method according to one of claims 16 to 22, wherein, in the step of photolithographic producing and of processing said gate trenches (12) and said connecting gate trench (22), at least one terminating trench (26) is produced which surrounds an active region of said power MOS element, the active region being established by said plurality of gate trenches and said connecting gate trench (22).

24. Method according to one of claims 16 to 23, wherein, after the photolithographic producing of said contact holes (56), a contact hole implantation (64) is carried out to enable a low-resistance contact to said channel region (44).

25. Method according to one of claims 16 to 24, wherein, after the step of the photolithographic producing of said contact holes, a further contact hole implantation (66) is carried out to modify the doping profile of said channel region (44) and said drift region (42).

26. Method according to one of claims 16 to 25, wherein said contact holes (56) are filled with a conductive material (60), whereby said source region (46) and said channel region (44) are short-circuited and said connecting gate trench (22) is contacted.

27. Method according to one of claims 16 to 26, wherein, prior to the photolithographic producing of said gate contact (24), said source and said channel contacts (20), a full area metal layer (62) comprising tungsten, aluminium or a combination of tungsten and aluminium is deposited.

28. Method according to one of claims 16 to 27, wherein, in the step of the photolithographic producing of said gate contact (24), said source contact and said channel contact (20), a source contact (20) is produced which essentially extends over the whole surface of said power MOS element, except for a region around said connecting gate (22) in which said gate contact (24) is located.

29. Method according to one of claims 23 to 28, wherein, in the step of the photolithographic producing and processing of said gate trenches (12) and said connecting gate trench (22), a plurality of terminating trenches (26) which are not contacted and whose mutual distance increases towards the margin of said power MOS element is formed.

30. Method according to one of claims 23 to 28, wherein said terminating trench has a width which is 5 to 25 times as big as the width of a gate trench (12), and wherein, in the step of the photolithographic producing of said contact holes, a contact hole (72) is produced in said source region (46) and said channel region (44) next to said terminating trench (26') and in an electrically conductive material (52) at the margin of said terminating trench (26'), and wherein, in the step of the photolithographic producing of said gate contacts (24), said source contact and said channel contact (22), a metallic connection (74) between said contact hole (70) in said terminating trench (26') and said contact hole (72) in said source region (46) and said channel region (44) is produced to produce a field-plate-like structure.

31. Method according to one of claims 28 to 30, wherein said connecting gate trench, said source contact (20) and said gate contact (24) are arranged in such a way that said gate contact (24) is essentially located in the middle of said power MOS element.

32. Method according to claim 16 or 17, wherein the step of processing said gate trenches (12) comprises the following substeps:
producing a gate oxide (50) in said gate trenches (12);
depositing a layer of polysilicon onto said gate oxide (50);
depositing tungsten onto said polysilicon;
thermal treating of said arrangement in such a way that a silicidation takes place.

33. Method according to claim 16 or 17,
wherein the step of providing comprises the following steps:
implanting a channel region (44) into a semiconductor substrate which is doped with a first doping type; and
implanting said source region (46) into said semiconductor substrate.
and which, after the step of the photolithographic producing of said gate contact (24), said source contact (20) and said channel contact (20), further comprises the following steps:
grinding back said semiconductor substrate on that side which is opposite to the side in which said gate trenches (12) are formed;
implanting a highly doped region into said semiconductor substrate from that side which is ground back; and
depositing a rear side metalization to produce a drain contact.

## Revendications

1. Composant de puissance MOS, aux caractéristiques suivantes :
une zone de dérive (42) à dopage d'un premier type;
une zone de canal (44) à dopage d'un second type, le second type de dopage étant complémentaire au premier type de dopage, et la zone de canal (44) étant adjacente à la zone de dérive (42) ;
une zone de source (46) à dopage du premier type, la zone de source (46) étant adjacente à la zone de canal (44) ;
une structure de contact de source (20, 60) pour la mise en contact de la zone de source (46) ; et
une structure de contact de canal (20, 60) pour la mise en contact de la zone de canal (44) ;
**caractérisé par**
une pluralité de fosses de porte (12) sensiblement parallèles, distantes l'une de l'autre, définissant une zone active du composant de puissance MOS et s'étendant à travers la zone de source (46), la zone de canal (44) et dans la zone de dérive (42), les fosses de porte présentant du matériau électroconducteur (52) isolé électriquement, par un isolateur (50), de la zone de source (46), de la zone de canal (44) et de la zone de dérive (42) ;
une fosse de porte de raccordement (22) pour la connexion électroconductrice de la fosse de porte (12) s'étendant à travers la zone de source (46), la zone de canal (44) et dans la zone de dérive (42), la fosse de porte de raccordement (22) présentant du matériau électroconducteur (52) isolé électriquement, par un isolateur (50), de la zone de source (46), de la zone de canal (44) et de la zone de dérive (42), la fosse de porte de raccordement (22) étant une fosse entourante présentant une première zone de connexion (22a), une seconde zone de connexion, une première zone longitudinale (22b) et une seconde zone longitudinale, la première zone de connexion (22a) reliant entre elles des premières extrémités de la pluralité de fosses de porte (12), la seconde zone de connexion reliant entre elles des secondes extrémités de la pluralité de fosses de porte (12), et la première et la seconde zone longitudinale (22b) reliant entre elles la première et la seconde zone de connexion (22a), de sorte que la zone active définie par la pluralité de fosses de porte (12) est entièrement entourée par la fosse de porte de raccordement (22) ; et
un contact de porte (24) pour la mise en contact de la fosse de porte de raccordement (22), le contact de porte (24) étant relié, par l'intermédiaire d'un trou de contact (56), rempli de matériau électroconducteur (60), dans l'isolateur (50) de la fosse de porte de raccordement, avec le matériau électroconducteur (52) de la fosse de porte de raccordement (22).

2. Composant de puissance MOS, aux caractéristiques suivantes :
une zone de dérive (42) à dopage d'un premier type;
une zone de canal (44) à dopage d'un second type, le second type de dopage étant complémentaire au premier type de dopage, et la zone de canal (44) étant adjacente à la zone de dérive (42) ;
une zone de source (46) à dopage du premier type, la zone de source (46) étant adjacente à la zone de canal (44);
une structure de contact de source (20, 60) pour la mise en contact de la zone de source (46) ; et
une structure de contact de canal (20, 60) pour la mise en contact de la zone de canal (44);
**caractérisé par**
une pluralité de fosses de porte (12) sensiblement parallèles, distantes l'une de l'autre, définissant une zone active du composant de puissance MOS et s'étendant à travers la zone de source (46), la zone de canal (44) et dans la zone de dérive (42), les fosses de porte présentant du matériau électroconducteur (52) isolé électriquement, par un isolateur (50), de la zone de source (46), de la zone de canal (44) et de la zone de dérive (42) ;
une fosse de porte de raccordement (22) pour la connexion électroconductrice de la fosse de porte (12) s'étendant à travers la zone de source (46), la zone de canal (44) et dans la zone de dérive (42), la fosse de porte de raccordement (22) présentant du matériau électroconducteur (52) isolé électriquement, par un isolateur (50), de la zone de source (46), de la zone de canal (44) et de la zone de dérive (42), la fosse de porte de raccordement (22) présentant un tronçon entourant. (22a) qui entoure une zone non-active du composant de puissance MOS dans laquelle ne se trouvent pas de fosses de porte, et des tronçons de bras reliés de manière électroconductrice au tronçon entourant et reliant entre elles, de manière électroconductrice, au moins une partie des fosses de porte ; et
un contact de porte (24) pour la mise en contact de la fosse de porte de raccordement (22), le contact de porte (24) étant relié, par l'intermédiaire d'un trou de contact (56), rempli de matériau électroconducteur (60), dans l'isolateur (50) de la fosse de porte de raccordement, avec le matériau électroconducteur (52) de la fosse de porte de raccordement (22).

3. Composant de puissance MOS selon la revendication 1 ou 2, dans lequel la largeur de la fosse de porte de raccordement (22) destinée à recevoir le trou de contact (56) est plus grande que la largeur de l'une de la pluralité de fosses de porte (12).

4. Composant de puissance MOS selon l'une des revendications précédentes, dans lequel l'angle entre l'une de la pluralité de fosses de porte (12) et la fosse de porte de raccordement (22) est sensiblement de 90°.

5. Composant de puissance MOS selon l'une des revendications 1, 3 ou 4, dans lequel le contact de porte (24) est disposé sur un bord (68) du composant de puissance MOS et ne s'étend que partiellement sur une zone active du composant de puissance MOS.

6. Composant de puissance MOS selon l'une des revendications 2 à 4, dans lequel le contact de porte (24) est disposé sensiblement au centre du composant de puissance MOS et s'étend tout au plus partiellement ou ne s'étend pas du tout sur une zone active du composant de puissance MOS.

7. Composant de puissance MOS selon l'une des revendications 2 à 4 ou 6, dans lequel le tronçon entourant (22a) de la fosse de porte de raccordement présente deux zones de connexion disposées sensiblement perpendiculairement à la fosse de porte, les tronçons de bras (22c à 22f) étant orientés dans le même sens que les zones de connexion.

8. Composant de puissance MOS selon l'une des revendications 2 à 4, 6 ou 7, présentant une forme rectangulaire, la pluralité de fosses de porte (12) présentant quatre sous-groupes, les fosses de porte (12) de chaque sous-groupe étant parallèles, chacune, à un bord du composant de puissance MOS et les tronçons de bras de la fosse de porte de raccordement (22) s'étendant, chacun, diagonalement aux quatre coins du composant de puissance MOS, en direction de la fosse de porte de raccordement (22) entourante, afin de relier entre elles, de manière électroconductrice, les fosses de porte.

9. Composant de puissance MOS selon l'une des revendications précédentes, présentant, par ailleurs, une structure de terminaison de bord (26) entourant entièrement une zone active du composant de puissance MOS.

10. Composant de puissance MOS selon la revendication 9, dans lequel la structure de terminaison de bord présente une pluralité de fosses de terminaison (26a, 26b) s'étendant de manière parallèle, qui ne sont pas mises en contact et dont l'écartement entre elles augmente en direction du bord du composant de puissance MOS, afin de satisfaire à une classe de tension de blocage déterminée.

11. Composant de puissance MOS selon la revendication 9, dans lequel la structure de terminaison de bord présente une partie d'une fosse de terminaison (26') présentant, à son bord vis-à-vis de la zone de source, de la zone de drain et de la zone de canal, du matériau électroconducteur (52) isolé par un isolateur (50), le matériau électroconducteur (52) de la structure de terminaison de bord étant relié de manière électroconductrice, par l'intermédiaire d'un trou de contact (70), d'une métallisation de surface (74) et d'un trou de contact (72), à la zone de source (46) et à la zone de drain (44), le bord (68) du composant de puissance MOS s'étendant dans la fosse de terminaison (26').

12. Composant de puissance MOS selon l'une des revendications précédentes, dans lequel la structure de contact de source et la structure de contact de canal présentent un trou de contact (56) commun, rempli de matériau électroconducteur (60), s'étendant à travers la zone de source (46) et dans la zone de canal (44), de sorte que la zone de source (46) et la zone de canal (44) puissent être maintenus, à l'aide d'un seul contact, au même potentiel.

13. Composant de puissance MOS selon l'une des revendications précédentes, dans lequel la zone de dérive (42), la zone de canal (44) et la zone de source (46) sont des couches planes sur une couche de substrat (40) fortement dopée à dopage du premier type.

14. Composant de puissance MOS selon l'une des revendications 1 à 12, dans lequel la zone de dérive (42), la zone de canal (44) et la zone de source (46) sont des couches planes sur une couche de substrat fortement dopée à dopage du premier type.

15. Composant de puissance MOS selon la revendication 12, dans lequel, par suite d'une implantation de trou de contact (66) dans le trou de contact (56), la limite entre la zone de canal et la zone de source n'est pas parallèle à une surface principale du composant de puissance MOS.

16. Procédé de fabricant d'un composant de puissance MOS selon la revendication 1 ou 2, aux étapes suivantes consistant à :
préparer un substrat avec une zone de dérive (42) à dopage d'un premier type, une zone de canal (44) à dopage d'un second type, le second type de dopage étant complémentaire au premier type de dopage, et la zone de canal (44) étant adjacente à la zone de dérive (42), et une zone de source (46) à dopage du premier type, la zone de source (46) étant adjacente à la zone de canal (44) ;
générer photolithographiquement (48) des fosses de porte (12) sensiblement parallèles, distantes l'une de l'autre, définissant une zone active du composant de puissance MOS et une fosse de porte de raccordement (22) par laquelle la pluralité de fosses de porte (12) sensiblement parallèles peuvent être reliées entre elles de manière électroconductrice, de sorte que celles-ci s'étendent à travers la zone de source (46), la zone de canal (44) et dans la zone de dérive (42),
la fosse de porte de raccordement (22) étant une fosse entourante présentant une première zone de connexion (22a), une seconde zone de connexion, une première zone longitudinale (22b) et une seconde zone longitudinale, la première zone de connexion (22a) reliant entre elles des premières extrémités de la pluralité de fosses de porte (12), la seconde zone de connexion reliant entre elles des secondes extrémités de la pluralité de fosses de porte (12), et la première et la seconde zone longitudinale (22b) reliant entre elles la première et la seconde zone de connexion (22a), de sorte que la zone active définie par la pluralité de fosses de porte (12) est entièrement entourée par la fosse de porte de raccordement (22) ; ou
la fosse de porte de raccordement (22) présentant un tronçon entourant (22a) qui entoure une zone non-active du composant de puissance MOS dans laquelle ne se trouvent pas de fosses de porte, et des tronçons de bras reliés de manière électroconductrice au tronçon entourant et reliant entre elles, de manière électroconductrice, au moins une partie des fosses de porte ;
traiter les fosses de porte (12) et la fosse de porte de raccordement (22) pour qu'elles présentent du matériau conducteur (52) séparé, par un isolateur (50) de la zone de source (46), de la zone de canal (44) et de la zone de dérive (42) ;
générer photolithographiquement des trous de contact (56) pour la mise en contact de la zone de source (46), de la zone de canal (44) et de la fosse de porte de raccordement (22), la fosse de porte de raccordement (22) pouvant être mise en contact par l'intermédiaire des trous de contact associés à la fosse de porte de raccordement (22) ;
remplir les trous de contacts (26) d'un matériau électroconducteur (60) ; et
générer photolithographiquement le contact de porte (24), le contact de source (20) et le contact de canal (20).

17. Procédé selon la revendication 16, dans lequel les étapes de génération photolithographique présentent, chacun, une étape de réalisation d'un masque et une étape de décapage jusqu'à une profondeur spécifiée.

18. Procédé selon la revendication 16 ou 17, dans lequel l'étape de préparation présente les étapes suivantes consistant à :
implanter une zone de canal (44) dans un substrat à semi-conducteur dopé par le premier type de dopage ; et
implanter la zone de source (46) dans le substrat à semi-conducteur.

19. Procédé selon la revendication 16 ou 17, dans lequel l'étape de préparation d'un substrat présente les étapes suivantes consistant à :
générer par croissance épitactique la zone de canal (44) sur un substrat à semi-conducteur ;
implanter la zone de source (46) dans la zone de canal (44) générée par croissance épitactique.

20. Procédé selon l'une des revendications 16 à 19, dans lequel, après l'étape de génération photolithographique des fosses de porte (12) et de la fosse de porte de raccordement (22), il est effectué au moins une oxydation de nettoyage avec élimination successive de l'oxyde de nettoyage.

21. Procédé selon l'une des revendications 16 à 20, dans lequel l'étape de traitement de la fosse de porte (12) et de la fosse de porte de raccordement (22) présente les étapes suivantes consistant à :
effectuer une oxydation de porte, pour générer l'isolateur (50) ;
remplir les fosses oxydées du matériau électroconducteur (52) ;
éliminer le matériau conducteur, de sorte que seul reste le matériau conducteur dans les fosses ; et
appliquer un oxyde intermédiaire (54).

22. Procédé selon la revendication 21, dans lequel l'oxyde intermédiaire (54) présente des oxydes DCV dopés ou non-dopés, tels que par exemple du verre au silicate de bore-phosphore (VSBP), ou de l'oxyde de silane ou des combinaisons d'oxyde et de nitrure.

23. Procédé selon l'une des revendications 16 à 22, dans lequel, à l'étape de génération photolithographique et de traitement des fosses de porte (12) et de la fosse de porte de raccordement (22), il est généré au moins une fosse de terminaison (26) s'étendant autour d'une zone active du composant de puissance MOS fixée par la pluralité de fosses de porte et par la fosse de porte de raccordement (22).

24. Procédé selon l'une des revendications 16 à 23, dans lequel, après l'étape de génération photolithographique des trous de contact (56), il est effectué une implantation de trou de contact (64), pour permettre un contact faible ohmique avec la zone de canal (44).

25. Procédé selon l'une des revendications 16 à 24, dans lequel, après l'étape de génération photolithographique des trous de contact, il est effectué une autre implantation de trou de contact (66), pour modifier le profil de dopage de la zone de canal (44) et de la zone de dérive (42).

26. Procédé selon l'une des revendications 16 à 25, dans lequel les trous de contact (56) sont remplis de matériau conducteur (60), par le fait de quoi la zone de source (46) et la zone de canal (44) sont court-circuitées et la fosse de porte de raccordement (22) est mise en contact.

27. Procédé selon l'une des revendications 16 à 26, dans lequel, avant la génération photolithographique du contact de porte (24), du contact de source et du contact de canal (20), il est appliqué, sur toute la surface, une couche métallique (62) présentant du wolfram, de l'aluminium ou une combinaison de wolfram et d'aluminium.

28. Procédé selon l'une des revendications 16 à 27, dans lequel, à l'étape de génération photolithographique du contact de porte (24), du contact de source et du contact de canal (20), il est généré un contact de source (20) s'étendant sensiblement sur toute la surface du composant de puissance MOS, à l'exception d'une zone autour de la fosse de porte de raccordement (22) dans laquelle se situe le contact de porte (24).

29. Procédé selon l'une des revendications 23 à 28, dans lequel, à l'étape de génération photolithographique et de traitement des fosses de porte et de la fosse de porte de raccordement (22), il est généré une pluralité de fosses de terminaison (26) qui ne sont pas mises en contact et dont la distance relative par rapport au bord du composant de puissance MOS augmente.

30. Procédé selon l'une des revendications 23 à 28, dans lequel la fosse de terminaison présente une largeur qui est de 5 à 25 fois plus grande que la largeur d'une fosse de porte (12) et dans lequel, à l'étape de génération photolithographique de trous de contact, il est généré un trou de contact (72) dans la zone de source (46) et dans la zone de canal (44) à côté de la fosse de terminaison (26') et dans un matériau électroconducteur (52) au bord de la fosse de terminaison (26'), et dans lequel, à l'étape de génération photolithographique du contact de porte (24), du contact de source et du contact de canal (22), il est généré une connexion métallique (74) entre le trou de contact (70) dans la fosse de terminaison (26') et le trou de contact (72) dans la zone de source (46) et la zone de canal (44), pour générer une structure en forme de plaque de champ.

31. Procédé selon l'une des revendications 28 à 30, dans lequel la fosse de porte de raccordement, le contact de source (20) et le contact de porte (24) sont disposés de telle sorte que le contact de porte (24) se situe sensiblement au centre du composant de puissance MOS.

32. Procédé selon la revendication 16 ou 17, dans lequel l'étape de traitement des fosses de porte (12) présente les étapes partielles suivantes consistant à :
générer un oxyde de porte (50) dans les fosses de porte (12) ;
appliquer une couche de polysilicium sur l'oxyde de porte (50) ;
appliquer du wolfram sur le polysilicium ;
traiter thermiquement l'aménagement, de sorte qu'il se produise une siliciuration.

33. Procédé selon la revendication 16 ou 17,
dans lequel l'étape de préparation présente les étapes suivantes consistant à :
implanter une zone de canal (44) dans un substrat à semi-conducteur dopé par le premier type de dopage ; et
implanter la zone de source (46) dans le substrat à semi-conducteur,
et présentant, après l'étape de génération photolithographique du contact de porte (24), du contact de source (20) et du contact de canal (22), par ailleurs, présente les étapes partielles suivantes consistant à :
meuler le substrat à semi-conducteur du côté opposé au côté dans lequel sont formées les fosses de porte (12) ;
implanter une zone hautement dopée dans le substrat à semi-conducteur, depuis le côté meulé ; et
appliquer une métallisation du côté arrière, pour créer un contact de drain.
